# EUROPÄISCHE PATENTSCHRIFT

(11) **EP 0 555 764 B1**
(45) Veröffentlichungstag und Bekanntmachung des Hinweises auf die Patenterteilung: **11.06.1997**
(21) Anmeldenummer: 93101696.8
(22) Anmeldetag: 04.02.1993
(51) Int. Cl.: C23C 14/56, F16K 51/02, H01L 21/00

(54) **Vakuumbearbeitungsanlage**
Vacuum-processing apparatus
Appareillage de traitement sous vide

(30) Priorität: 12.02.1992 CH 419/92
(43) Veröffentlichungstag der Anmeldung: 18.08.1993
(73) Patentinhaber: BALZERS AKTIENGESELLSCHAFT, 9496 Balzers (LI)
(72) Erfinder: Strasser, Gregor, Dr., FL-9490 Vaduz (LI); Good, Pius, CH-8887 Mels (CH); Steinmann, Jürg, CH-8880 Walenstadt (CH); Schertler, Roman, A-6922 Wolfurt (AT)
(74) Vertreter: Troesch Scheidegger Werner AG

(56) Entgegenhaltungen:
- EP-A- 0 244 950
- EP-A- 0 370 188
- DE-A- 2 227 983
- FR-A- 199 817
- GB-A- 2 152 195
- US-A- 3 158 499
- US-A- 3 711 062

## Beschreibung

Die vorliegende Erfindung betrifft eine Vakuumbearbeitungsanlage für das Oberflächenbehandeln von Substraten und Werkstücken, mit mindestens zwei Stationen, wobei mindestens eine Station eine Bearbeitungsstation ist, eine Verwendung der Anlage für das Bearbeiten von Substraten oder Werkstücken, sowie ein Verfahren für das dichte Abschliessen bzw. Abtrennen einer Vakuumbearbeitungsanlage.

Zur Bearbeitung von Werkstücken werden in einer Vakuumkammer je nach dem durchzuführenden Vakuumprozess bestimmte Arbeitsdrücke verlangt. Beim Einbringen von Werkstücken von Atmosphäre in die Vakuumkammer oder von einer Bearbeitungskammer in eine andere müssen jeweils dichtende Trennelemente vorgesehen werden. Dazu werden in bekannter Weise Türen, Ventile bzw. ganze Schleusenvorrichtungen vorgesehen.

Zur Durchführung von mehreren parallelen Behandlungsschritten in Vakuumprozessanlagen (z.B. mehrlagiger Beschichtungen) besteht häufig die Notwendigkeit, die Prozesskammern während der Durchführung der Prozesse voneinander zu separieren. Dies wird üblicherweise durch die Verwendung von Trennventilen erreicht. Um die Substrate einer Kammer zur nächsten zu transportieren, werden die Trennventile geöffnet und die Werkstücke durch Transporteinheiten um jeweils einen Schritt weiterbewegt. Diese Transporteinrichtungen müssen jeweils vor dem Schliessen bzw. Aktivieren der Trennventile den Oeffnungsbereich der Ventile verlassen haben, um ein dichtes Abtrennen der jeweiligen Prozesskammern zu ermöglichen. Damit geht zum einen wertvolle Zeit verloren, zum zweiten muss das Transportsystem, bedingt durch das Problem der Durchdringung, aus mehreren Teileinheiten bestehen.

Ein Lösungsansatz für das Beheben dieses Problems wird in der EP-A-0 370 188 beschrieben, indem eine Transporteinrichtung vorgeschlagen wird, welche das Beschicken und Entleeren einer Bearbeitungskammer wesentlich vereinfacht und beschleunigt. Das Grundprinzip besteht darin, dass die Transportvorrichtung aus einzelnen, jeweils in den Bearbeitungskammern angeordneten, schwenkgelagerten Hebeleinrichtungen gebildet wird, welche durch die geöffneten schlitzförmigen Ventile hindurchgreifen.

Eine weitere Lösung besteht darin, dass ein zu behandelndes Objekt derart in eine Bearbeitungskammer mittels eines Transportmechanismus eingeführt wird, dass durch den Mechanismus selbst und die Bewegung in Richtung Kammer letztere dicht abgeschlossen wird, um die Bearbeitung durchführen zu können.

In ähnlicher Art und Weise beschreibt die EP-A- 0 244 950 eine Mehrfach-Oberflächenbehandlungsanlage für die Behandlung von flächigen Gegenständen, wie beispielsweise von Wafern, wo diese Gegenstände auf einer bewegbaren bzw. rotierbaren Unterlage zwischen mehreren Arbeitsstationen in der Anlage transportiert werden. An den jeweiligen Stationen werden Dichtungsmittel an der Unterlage mit entsprechenden Dichtungsmitteln an einem Bearbeitungsraum in Eingriff gebracht, indem an der Unterlage und der Bearbeitungskammer kongruente, mit Dichtungen versehene Konturen aneinanderstossen und somit den Raum, beinhaltend das jeweilig zu behandelnde Substrat, dicht von der Umgebung abtrennen können.

Weitere Anlagevarianten zur Behandlung von Substraten bzw. zur Herstellung von dünnen Schichten werden in den DE 24 54 544, DE 26 09 115, DE 24 20 430, DE 40 09 603, DE 37 16 498, DE 37 35 284, DE 39 12 297, DE 39 12 295 und der US 3 874 525 vorgeschlagen.

In der DE-A- 34 25 267 wird eine Vakuumbearbeitungsanlage mit mehreren Bearbeitungsstationen beschrieben, wobei ein speziell ausgebildetes Transportsystem vorgesehen ist, umfassend ein vertikales und ein horizontales Transportmittel. Die Isolation der einzelnen Stationen von der Hauptkammer erfolgt wiederum dadurch, dass an einem vertikalen Transportmittel Abdichtmittel vorgesehen sind, welche beim Einführen des zu behandelnden Substrates in die Behandlungskammer letztere dicht abtrennen.

Analog wird in der GB 2 152 195 ein Ventil vorgeschlagen, wo ein Ventilteller mittels hydraulischen oder pneumatischen Mitteln verschliessbar bzw. abdichtbar ist. Aus der FR 1 199 817 sind pneumatisch betätigbare Dichtungen bekannt.

Alle beschriebenen Anlagen haben gemeinsam, dass mittels eines Transportmittels Substrathalterungen oder die Substrate selbst in eine oder mehrere Behandlungskammern geführt bzw. transportiert werden, um in dieser oder diesen Kammern unter Vakuum oberflächenbehandelt zu werden. Nebst diesen Transportmitteln ist mindestens ein weiterer Transport- bzw. Bewegungsmechanismus notwendig, um Dichtungsmittel im Behandlungsraum bzw. an der oder den Prozesskammern und entsprechende Dichtungsmittel, beispielsweise am Substrat selbst oder an einer Unterlage, auf welchem das Substrat transportiert wird, in gegenseitigen An- bzw. Eingriff zu bringen, damit die Kammer oder die Kammern für die Durchführung eines Bearbeitungsprozesses dicht abgeschlossen werden können. Zum einen muss ein derartiger An- bzw. Eingriff der Dichtungsmittel genau aufeinanderpassend sein, damit eine gute Dichtung gewährleistet ist, und zudem sind die genannten Transport- bzw. Bewegungsmittel und Mechanismen Quellen möglicher Kontamination in diesen Kammern, es sei denn, dass die verschiedenen Transportmechanismen durch aufwendige Balgsysteme vom Rauminnern der Anlage bzw. den Kammern getrennt sind, um Verunreinigungen zu verhindern.

Die Aufgabe der vorliegenden Erfindung besteht daher darin, eine Vakuumprozessanlage bzw. einzelne Prozesskammern oder Kammerteile der Anlage dichtend abzuschliessen bzw. dichtend voneinander zu trennen, wobei dies mit geringem Aufwand an mechanischen Bewegungseinrichtungen zu erfolgen hat, um die entsprechenden Anlagekonstruktionen stark zu vereinfachen und um die Wirtschaftlichkeit zu erhöhen.

Eine weitere Aufgabe besteht darin, dass bei aufwendigen Anlagen mit mehreren Prozesskammern auftretende Durchdringungsprobleme mit besonders vereinfachter Bewegungsmechanik gelöst werden können.

Die Lösung der gestellten Aufgabe wird mittels einer Vakuumbearbeitungsanlage gemäss dem Wortlaut nach einem der Ansprüche 1 oder 2 gelöst.

Das Grundprinzip der erfindungsgemäss vorgeschlagenen Vakuumbearbeitungsanlage besteht darin, dass das Abdichten der Anlage bzw. von einer oder mehreren Prozesskammern in der Anlage mittels pneumatisch oder hydraulisch betätigbarer bzw. aktivierbarer Dichtungen erfolgt. Diese Dichtungen weisen einen Hohlkern auf, d.h. sie sind schlauch-, balg- oder ballonartig ausgebildet oder werden durch eine membranartige Anordnung gebildet. Durch Einführen eines Gases oder einer Flüssigkeit in den Kern bzw. ins Innere dieser Dichtung bzw. an die Rückseite der Membran wird die Oberfläche der Dichtung bzw. Membran derart durch Dehnung bzw. durch Auslenkung des Balges vergrössert und/oder bewegt, dass die Anlage oder Teile davon dicht abgeschlossen bzw. abgetrennt werden kann bzw. können.

Entsprechend sind diese Dichtungen aus einem elastischen und/oder dehnbaren Material zu fertigen, wie beispielsweise einem natürlichen oder synthetischen Kautschuk oder einem elastischen oder flexiblen thermoplastischen Material oder einem elastomeren Material. Auch federelastische Metallschläuche oder Membranen sowie metallene Bälge sind geeignet. Letztere können an den Dichtflächen zur besseren Dichtwirkung mit einem elastischen Kunststoff oder einem gummiartigen Material versehen sein.

Das zu wählende Dichtungsmaterial muss einerseits eine ausreichende Festigkeit aufweisen, damit auch bei relativ hohen Druckunterschieden zwischen einem äusseren und einem inneren, dicht abzutrennenden Anlagebereich die jeweilige Dichtung nicht seitlich weggedrückt wird, und anderseits muss das Material je nach durchzuführendem Bearbeitungsprozess eine hohe Wärmebeständigkeit aufweisen wie auch eine spezifische Chemikalienbeständigkeit.

Je nach durchzuführenden Bearbeitungsprozessen eignen sich als Dichtungsmaterialien natürlicher oder synthetischer Kautschuk sowie Kunststoffmaterialien, wie insbesondere Elastomere. Geeignete Materialien können z.B. dem Firmenkatalog No. 10/57 BE 40186 der Firma Angst & Pfister, CH-Zürich, auf den Seiten 7 bis 20 entnommen werden.

Derartig hydraulisch bzw. pneumatisch betätigbare Dichtungen sind an sich aus dem Stand der Technik bekannt. Sie werden beispielsweise von A. ROTH, VACUUM SEALING TECHNIQUES, PERGAMON PRESS, 1966, auf den Seiten 437 und 438, "Aufblasbare Gummi- und Stahlrohrdichtungen", beschrieben, für das dichtende Trennen von verschiedenen Kammern. Dabei geht es insbesondere um das Abdichten von zu evakuierenden Isolationsbereichen bei Glasscheiben. Auch von der Firma CEFIL'AIR werden in einem Firmenprospekt pneumatische Dichtungen angeboten, um einen unter Druck stehenden Raum oder einen unter Vakuum stehenden Raum abzudichten. Obwohl an sich diese Dichtungen bekannt sind, wurden sie von der Fachwelt bis heute als in der Hochvakuumtechnik nicht geeignet betrachtet und fanden somit keine Verwendung.

Die abzudichtende Vakuumbearbeitungsanlage kann eine oder mehrere Prozesskammern und/oder eine Schleusenkammer aufweisen, die je mittels pneumatisch oder hydraulisch aktivierbarer Dichtungen abschliessbar bzw. abtrennbar sind. Es ist dabei auch möglich, die Anlage oder die einzelnen Kammern, wenn grosse Querschnitte freigegeben werden sollen, welche die Dehnwege der jeweiligen Dichtung überschreiten, mit einem schieberartigen oder platten- oder tellerartigen Ventil dicht abzutrennen, wobei entlang der Abdichtungskontur des Schiebers, der Platte oder des Tellers am Ventil in dessen oder deren geschlossenem Zustand eine hydraulisch oder pneumatisch aktivierbare Dichtung angeordnet ist. So kann der Schieber, die Platte oder der Teller des Ventils zunächst geschlossen werden, wobei jedoch entlang der dichtenden Kontur noch keine Dichtwirkung erreicht wird. Statt einer weiteren Anpressbewegung des Schiebers, der Platte oder des Tellers, beispielsweise quer zur Schliessbewegung, um eine vollständige Dichtwirkung zu erzeugen, wird in einem weiteren Schritt die aktivierbare Dichtung betätigt und gegen die Abdichtungskontur gepresst, womit der Dichtungsvorgang abgeschlossen ist.

Der grosse Vorteil der Verwendung der hydraulisch bzw. pneumatisch aktivierbaren Dichtungen liegt darin, dass für das Erzeugen eines Vakuums in einer Vakuumbearbeitungsanlage auf mindestens einen Transport- bzw. Bewegungsmechanismus verzichtet werden kann, wodurch die Konstruktion einer Vakuumbearbeitungsanlage wesentlich vereinfacht werden kann. Im Prinzip verbleibt nur noch der Bewegungs- bzw. Transportmechanismus, um die zu behandelnden Substrate oder Werkstücke in die Anlage einzuführen und/oder in der Anlage zwischen den verschiedenen Bearbeitungskammern zu transportieren. Im Falle der Verwendung von Schiebern, Platten oder Tellern in Ventilen für das dichtende Abtrennen der Anlage bzw. von Kammern kann auf eine Anpressbewegung verzichtet werden, um den Schieber, die Platte oder den Teller an eine Dichtung zu pressen.

Eine erfindungsgemäss vorgeschlagene Vakuumbearbeitungsanlage umfasst vorzugsweise eine oder mehrere Bearbeitungsstationen und/oder eine Schleusenkammer sowie eine oder mehrere kammerartige Aufnahmen bzw. wenigstens einseitig offene Behältnisse für die Aufnahme von Substraten oder Werkstücken im Inneren der Aufnahme bzw. des Behältnisses. Diese Aufnahmen bzw. Behältnisse werden mittels eines Transportmechanismus zwischen den einzelnen Bearbeitungsstationen verschoben bzw. ausgetauscht, wobei an einem Teil oder allen Stationen pneumatisch oder hydraulisch aktivierbare Dichtungen vorgesehen sind, um die kammerartigen Aufnahmen bzw. Behältnisse in der jeweiligen Position an einer Bearbeitungsstation für die Durchführung eines Bearbeitungsprozesses dicht abzutrennen bzw. abzuschliessen.

Handelt es sich beispielsweise um eine Vakuumbearbeitungsanlage für das Behandeln von flächigen Substraten oder Werkstücken, wie beispielsweise von Wafern und wie in der EP-A 244 950 beschrieben, so können die kammerartigen Aufnahmen bzw. einseitig offenen Behältnisse dergestalt sein, dass sie nur eine geringe Höhe aufweisen, ausreichend für die vollständige Aufnahme des flächigen Substrates. Der Transportmechanismus kann in diesem Fall eine Transportplatte oder ein Transportband sein, in welchem die, eine geringe Tiefe aufweisenden Aufnahmen bzw. einseitig offenen Behältnisse eingelassen sind.

Die Anlage kann einen äusseren und mindestens einen inneren Anlagebereich umfassen, wobei am äusseren und/oder inneren Anlagebereich pneumatisch oder hydraulisch aktivierbare Dichtungen vorgesehen sind, um den äusseren und/oder inneren Anlagebereich dicht abzutrennen.

Der äussere Anlagebereich kann beispielsweise eine Hauptkammer, eine Schleusenkammer oder eine Verteilkammer umfassen und der innere Bereich eine oder mehrere Bearbeitungskammern, wobei die zu beschichtenden Substrate bzw. Werkstücke mittels eines Transportmechanismus in der Hauptkammer, der Schleusenkammer und/oder der Verteilkammer zwischen den verschiedenen Bearbeitungskammern ausgetauscht oder gefordert werden, wobei die Bearbeitungskammern mittels hydraulisch oder pneumatisch aktivierbarer Dichtungen gegenüber der Haupt-, der Schleusen- und/oder der Verteilkammer dicht trennbar sind.

Wiederum ist es ebenfalls möglich, die einzelnen Kammern mittels schieber-, platten oder tellerartigen Ventilen von der Haupt-, der Schleusen- oder der Verteilkammer zu trennen, wobei das dichtende Abtrennen durch pneumatisch bzw. hydraulisch aktivierbare Dichtungen im Bereich der Abdichtungskontur des Schiebers, der Platte oder des Tellers am Ventil in deren geschlossenem Zustand erfolgt, womit auf eine Anpressbewegung verzichtet werden kann.

Für das Behandeln von scheibenartigen oder flächigen Gegenständen, wie Wafern, wird weiter eine Anlage vorgeschlagen, in welcher flächige Transportunterlagen vorgesehen sind, um die Gegenstände zwischen mehreren Bearbeitungsstationen zu verschieben, wobei im Bereich eines Teils oder aller der Bearbeitungsstationen in Richtung gegen die flächige Transportunterlage hydraulisch oder pneumatisch aktivierbare Dichtungen vorgesehen sind, deren Ausdehnungsweg bzw. Hub in Richtung zur Transportunterlage derart ist, dass im zurückgezogenen Zustand der Dichtung die scheibenartigen Gegenstände frei in oder aus der Bearbeitungsstation verschiebbar sind, jedoch bei der Durchführung des Bearbeitungsprozesses durch das Aktivieren der Dichtung in Richtung zur Transportunterlage ein dichtes Abtrennen der Bearbeitungsstation gewährleistet ist.

Um beispielsweise die Dichtwirkung eines Ventils zu erhöhen, wird vorgeschlagen, parallel mehrere, pneumatisch oder hydraulisch aktivierbare Dichtungen zu betreiben, wobei zusätzlich zwischen zwei parallel angeordneten Dichtungen der Zwischenraum differentiell abgepumpt werden kann. Damit kann zusätzlich zur Erhöhung der Dichtwirkung ein sog. virtuelles Leck der Dichtung verhindert werden, indem im Zwischenraum zwischen den beiden parallel angeordneten Dichtungen durch zusätzliches Evakuieren ein definierter Zustand erzielt werden kann. Durch das Anordnen mehrerer paralleler Dichtungen kann aber auch die Belastung der einzelnen Dichtungen reduziert werden.

Weiter kann es vorteilhaft sein, die einzelnen hydraulisch oder pneumatisch aktivierbaren Dichtungen gegen allfällige Einflüsse im Innern einer Bearbeitungskammer durch Anbringen von Blenden, Labyrinthen oder Jalousien, wenigstens teilweise, abzuschatten bzw. zu schützen. Dies ist insbesondere dann notwendig, wenn Beschichtungs- bzw. Aetzprozesse an Substraten durchgeführt werden, wobei sich das Beschichtungsmedium an der Oberfläche der Dichtung absetzen kann, bzw. ein verwendetes Aetzmedium die Oberfläche der Dichtung angreifen kann.

Die erfindungsgemäss beschriebenen Vakuumbearbeitungsanlagen eignen sich für die Durchführung irgendwelcher Oberflächenbearbeitungsprozesse an Substraten oder Werkstücken. Insbesondere eignen sich die Anlagen für die Durchführung von PVD, CVD oder anderen Plasmaverfahren oder aber für die Durchführung von Aetz- oder irgendwelchen Beschichtungsprozessen.

Weiter wird ein Verfahren vorgeschlagen für das dichte Abschliessen bzw. Abtrennen einer Vakuumbearbeitungsanlage nach einem der Ansprüche 1-8 für das Oberflächenbehandeln von Substraten oder Werkstücken, indem eine oder mehrere hydraulisch oder pneumatisch aktivierbare Dichtungen durch das Einführen von Gas oder Flüssigkeit ins Innere der Dichtung derart aktiviert werden, dass deren Oberfläche derart vergrössert wird, dass zwischen dem Anlageinneren oder Teilbereichen davon und der jeweiligen Umgebung kommunizierende Oeffnungen dicht verschlossen werden. Insbesondere vorteilhaft ist das erfindungsgemässe Verfahren für das dichte Abschliessen bzw. Abtrennen von mehreren Bearbeitungsstationen in einer Vakuumbearbeitungsanlage für die Durchführung getrennter Bearbeitungsprozesse an Substraten oder Werkstücken, indem wenigstens an einem Teil der Stationen hydraulisch bzw. pneumatisch aktivierbare Dichtungen vorgesehen sind.

Diese Dichtungen werden während der Durchführung der Prozesse aktiviert, um die jeweilige Station dicht abzuschliessen, bzw. deaktiviert bzw. zurückgezogen, um ein Verschieben der Substrate bzw. Werkstücke zwischen den Stationen zu ermöglichen.

Die vorliegende Erfindung löst das Problem der Trennung von mehreren Bearbeitungskammern in einer umprozessanlage, indem der Vorteil einer gänzlichen Vakuumtrennung der einzelnen Kammern bei gleichzeitiger Lösung des eingangs erwähnten Bewegungs- bzw. Transportproblems beim Bewegen der Substrate in die verschiedenen Bearbeitungskammern und für das dichtende Abschliessen der einzelnen Kammern bzw. von Teilbereichen der Anlage erreicht wird.

So ist es gemäss der Erfindung möglich, den Spalt zwischen der jeweiligen Bearbeitungskammerwand und einem Transportmittel, in oder auf welchem das zu behandelnde Substrat oder Werkstück transportiert wird, mittels der erwähnten pneumatisch oder hydraulisch aktivierbaren Dichtungen derart zu schliessen, dass die getrennten Bearbeitungskammern entstehen. Allerdings unterliegen die zu wählenden Dichtungsmaterialien aufgrund des Anwendungsbereiches in einer Vakuumumgebung, speziell bei Drucken tiefer als 10⁻³mbar, strengeren Anforderungen als bei einem üblichen Einsatz in Atmosphäre oder bei einem Einsatz im Grobvakuumbereich. Die zu wählenden Dichtungen müssen in diesem Fall über eine geringe Abgas- und Permeationsrate verfügen, was beispielsweise durch die Verwendung der oben erwähnten verschiedenen Polymermaterialien, wie beispielsweise eines Fluorelastomeren, erreicht wird.

Ausserdem muss die Oberfläche der Dichtung frei von Unebenheiten und Defekten sein, damit eine geringe Leckrate bei der Separation der verschiedenen Bearbeitungskammern bzw. der Anlage selbst erreicht wird.

In Fällen, in welchen weniger hohe Anforderungen an die Vakuumtrennung gestellt werden, sind selbstverständlich auch geringere Anforderungen an die Dichtungsqualität gestellt. In gewissen einfacheren Fällen können dann sogar diffusionsspaltähnliche Bedingungen zugelassen werden, was den Einsatz der Dichtung nochmals beträchtlich vereinfacht.

Für das Abschliessen und Wiederöffnen der Anlage bzw. von Teilbereichen davon und/oder von einzelnen Bearbeitungsstationen ist es, wie bereits oben erwähnt, möglich, das Abdichten mittels Schiebern, Platten oder Tellern an Ventilen zu erreichen. Zum Abschliessen des entsprechenden Bereiches wird der jeweilige Schieber, die Platte oder der Teller am Ventil mittels einer translatorischen Bewegung geschlossen, und anschliessend wird entlang der Schliesskontur des Schiebers, der Platte oder des Tellers des Ventils statt einer Anpressbewegung eine hydraulisch oder pneumatisch aktivierbare Dichtung derart betätigt, dass durch die jeweilige Kontur ein vollständig dichter Abschluss bzw. eine dichte Trennung bewerkstelligt wird. Auf diese Art und Weise kann das Ventil dergestalt sein, dass der darin angeordnete Schieber, die Platte oder der Teller bzw. eine Tür ohne irgendwelche seitliche Reibung bewegt werden kann, indem durch die erwähnte translatorische Bewegung kein vollständiges Abdichten erreicht werden muss. Somit kann an der so genannten Dichtungskontur beim Oeffnen bzw. Schliessen des Ventils ein kleiner Spalt vorhanden sein, der dann mittels der hydraulisch bzw. pneumatisch aktivierbaren Dichtung dichtend überbrückt wird. Die vorerwähnte Funktionsweise ist auch vorteilhaft bei Schleusenanwendungen verwendbar.

Die Erfindung wird nun anschliessend beispielsweise und unter Bezug auf die beigefügten Figuren näher erläutert.

Dabei zeigen:
- Fig. 1a, 1b: das Grundprinzip des Aktivierens und Deaktivierens einer pneumatisch bzw. hydraulisch aktivierbaren Dichtung anhand von schematischen Skizzen,
- Fig. 1c: das Anbringen von seitlichen Blenden zum Schutz der Dichtung,
- Fig. 1d, - 1k: weitere bevorzugte Ausführungsvarianten von pneumatisch bzw. hydraulisch aktivierbaren Dichtungen,
- Fig. 2a, 2b und 2c: eine mögliche Ausführungsvariante einer erfindungsgemäss ausgebildeten Vakuumbearbeitungsanlage in schematischer Darstellung, im Längs- und im Querschnitt,
- Fig. 3a und 3b: eine weitere Ausführungsvariante einer erfindungsgemässen Vakuumbearbeitungsanlage, im Längsschnitt und im Querschnitt,
- Fig. 4a, 4b: wiederum eine weitere Vakuumbearbeitungsanlage, im Längsschnitt und im Schnitt von oben gesehen,
- und 4c: sowie im Querschnitt,
- Fig. 5: eine Vakuummehrfachbearbeitungsanlage mit vier voneinander getrennten Bearbeitungsstationen, im Schnitt von oben gesehen,
- Fig. 6: die Anlage von Fig. 5 im Schnitt entlang der Linie I-I,
- Fig. 7a und 7b: eine weitere Variante einer Bearbeitungskammer einer erfindungsgemässen Vakuumbearbeitungsanlage für flächige Substrate, im Schnitt von oben gesehen und im Querschnitt,
- Fig. 8: eine weitere Bearbeitungsanlage für das Behandeln bzw. Beschichten von flächigen Substraten, ähnlich der Anlage dargestellt in den Fig. 5 und 6 im Querschnitt,
- Fig. 9: eine weitere Ausführungsvariante einer erfindungsgemässen Vakuumbearbeitungsanlage mit mehreren Bearbeitungskammern, einer Hauptkammer sowie Einführ- und Ausführschleuse für das Ein- und Ausführen der Substrate in die Anlage,
- Fig. 10: die Anlage von Fig. 8, im Schnitt von oben gesehen,
- Fig. 11: die Ausgestaltung eines Ventils im Schnitt, für das dichte Unterbrechen einer Durchgangsöffnung, und
- Fig. 12 - 14: eine weitere Ausführungsvariante einer erfindungsgemässen Bearbeitungsanlage.

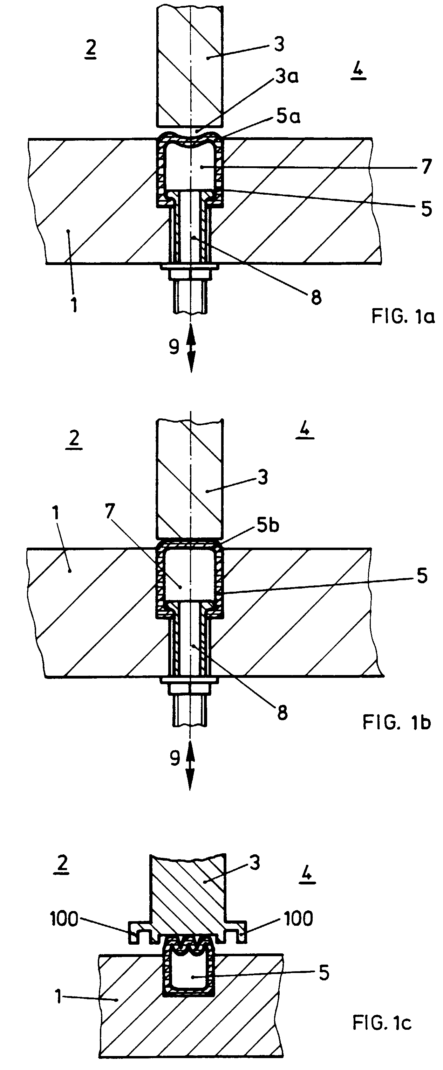

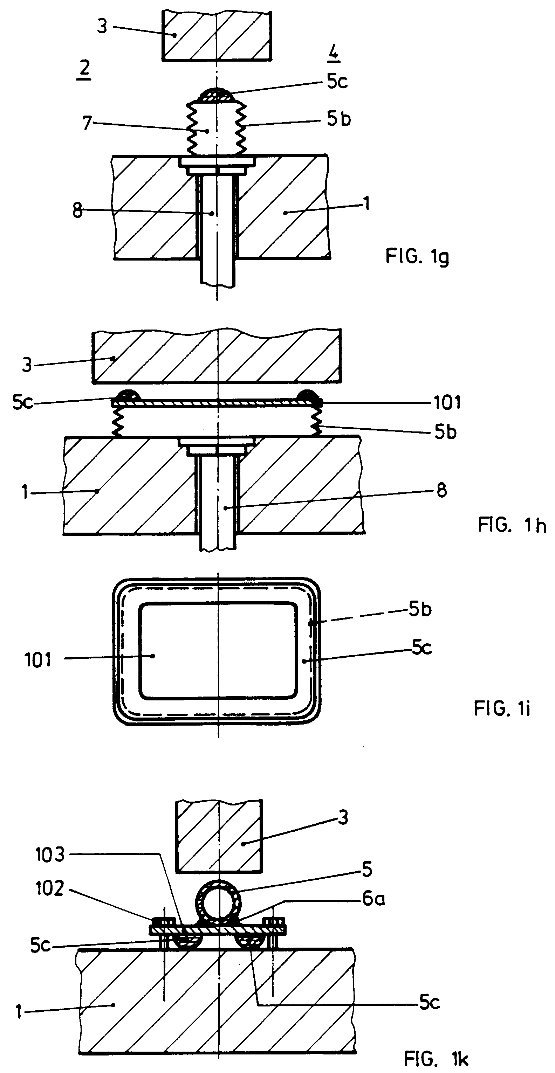

Anhand der Fig. 1a und 1b soll das Grundprinzip der Verwendung einer hydraulisch oder pneumatisch aktivierbaren Dichtung beschrieben werden.

In Fig. 1a ist im Schnitt der Teilbereich einer äusseren Wandung 1 einer Vakuumbearbeitungsanlage dargestellt sowie eine Zwischenwand 3 zwischen zwei Teilbereichen 2 und 4 im Inneren der Anlage. Die Zwischenwandung 3 schliesst dabei nicht dicht an die äussere Wandung 1 an, sondern lässt einen Spalt 3a frei, womit beispielsweise die Wandung 3 frei verschieblich in bezug auf die Wandung 1 angeordnet werden kann. In der äusseren Wandung 1 ist eine Dichtung 5 eingelassen, mit einer oberen Kontur 5a, welche gegen den Spalt 3a gerichtet ist. Die Dichtung 5 weist einen Hohlkern 7 auf, der über eine Leitung 8 mit einem pneumatischen oder hydraulischen System 9 verbunden ist.

In Fig. 1a ist dabei die Dichtung 5 deaktiviert bzw. zurückgezogen, und der Spalt 3a ist freigegeben.

Zum dichten Abschliessen der beiden Teilbereiche 2 und 4 wird nun die Dichtung 5 aktiviert, indem durch die Leitung 8 in den inneren Hohlraum der Dichtung 5 ein Gas oder eine Flüssigkeit eingepresst wird. Nun wird die obere Kontur 5b der Dichtung 5 gegen die Zwischenwandung 3 gepresst, womit die beiden Teilbereiche 2 und 4 dicht voneinander getrennt sind, wie in Fig. 1b erkennbar. Somit ist es beispielsweise möglich, den Teilbereich 2 zu evakuieren und in demselben einen Bearbeitungsprozess durchzuführen, der vom Teilbereich 4 abgetrennt zu erfolgen hat.

Wenn nun der Bearbeitungsprozess fertiggestellt ist, kann die Dichtung 5 deaktiviert werden, womit die obere Kontur 5a wieder in die Stellung der Fig. 1a zurückgezogen wird, und die Zwischenwandung 3 kann beispielsweise in die eine oder andere Richtung verschoben werden.

In Fig. 1c ist wiederum im Schnitt, analog der beiden Fig. 1a und 1b, eine Dichtung 5 dargestellt, welche dichtend an die Zwischenwandung 3 gepresst wird, um die beiden Teilbereiche 2 und 4 voneinander zu trennen. Um nun die gegenüber der Bearbeitungskammer 4 freie Oberfläche der Dichtung 5 gegenüber allfälligen Einflüssen in der Kammer 4 zu schützen, wie beispielsweise Schutz gegen ein Beschichtungsmedium, Schutz gegen allfällige Aetzsubstanzen, ist vorteilhafterweise eine Schutzblende 100 vorgesehen, um die genannte Oberfläche der Dichtung 5 abzuschatten. Anstelle der dargestellten Blende 100 kann selbstverständlich eine Jalousie, ein Labyrinth oder irgend ein anderes geeignetes Mittel vorgesehen werden, um die Dichtung 5 zu schützen.

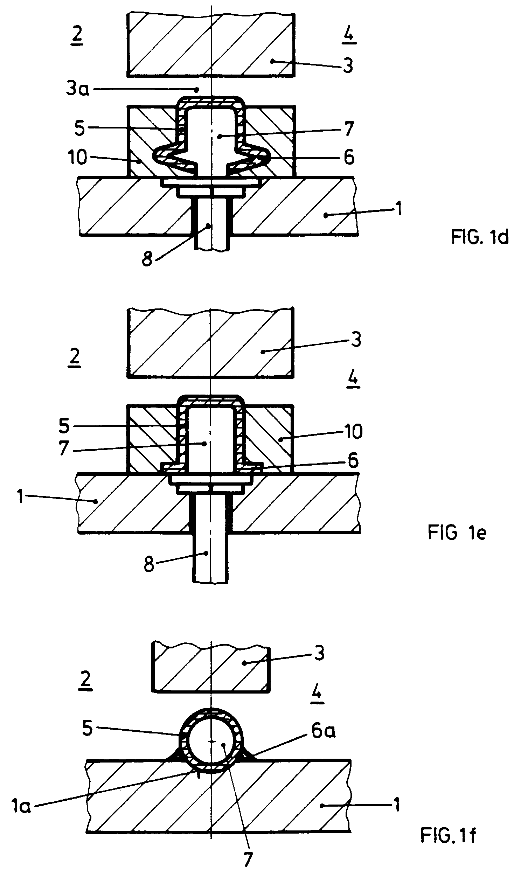

Die Fig. 1d bis 1k zeigen weitere Ausführungsvarianten von erfindungsgemässen pneumatisch bzw. hydraulisch aktivierbaren Dichtungen.

In den Fig. 1d und 1e sind je seitlich an der hydraulisch bzw. pneumatisch aktivierbaren und dehnbaren Dichtung 5 Führungen 10 angeordnet, um eine gerichtete Dehnbewegung der Dichtung 5 im Falle des Aktivierens zu gewährleisten. Zusätzlich wird die Dichtung 5 durch nockenartige bzw. wulstartige Elemente 6 in entsprechenden Aussparungen in den Führungen 10 gehalten. Im übrigen ist die Funktionsweise analog derjenigen der Dichtungen, dargestellt in den Fig. 1a bzw. 1b. Dichtungen gemäss den Ausführungsvarianten in den Fig. 1d und 1e werden dann verwendet, wenn die Dichtungen beispielsweise und nicht, wie die Dichtungen in den Fig. 1a bzw. 1b in die Unterlage eingelassen werden sollen. Wenn die Dichtungen beispielsweise leicht montier- und demontierbar von der Unterlage sein sollen, um sie auswechseln zu können, und nicht, wie die Dichtungen in den Fig. 1a bzw. 1b in die Unterlage eingelassen werden sollen. Die Führungsleisten 10 können beispielsweise verschraubt werden.

In Fig. 1f ist eine schlauchartige Dichtung dargestellt, welche beispielsweise in einer Einsenkung 1a der äusseren Wandung 1 eingelassen ist. Um ein seitliches Verrutschen bzw. Abheben der schlauchartigen Dichtung 5 von der Wandung 1 zu verhindern, kann diese beispielsweise mittels eines Klebstoffmaterials 6a auf der Wandung fixiert sein, oder aber unter Verwendung eines gummiartigen Materials direkt auf der Wandung 1 aufvulkanisiert werden.

In den Fig. 1g bis 1i werden balgartige Dichtungen beispielsweise dargestellt, umfassend beispielsweise einen metallenen Balg 5b. Der Vorteil der Verwendung eines metallenen Balges 5b liegt darin, dass mit einer erfindungsgemässen Dichtung 5 wesentlich grössere abzudichtende Zwischenräume überbrückt werden können und zudem die Dichtung selbst wesentlich stabiler ist. Dies eröffnet bei der konstruktiven Auslegung von abzudichtenden Teilen, wie Ventilanordnungen, Türen, Schleusen, abdichtbaren Anlageteilen wesentlich mehr Möglichkeit. Die zu dichtenden Elemente 1, 3, wie Anlage- bzw. Geräteelemente, wie Ventilplatten, Wandteile und andere müssen oft relativ gegeneinander bewegt werden können, ohne an der zurückgezogenen Dichtung zu reiben. Um frontseitig am Balg gegenüber der Zwischenwand 3 eine gute Abdichtung zu gewährleisten ist vorzugsweise frontseitig ein elastisches Material 5c, wie beispielsweise ein geeignetes Dichtmetall oder ein geeignetes Polymer, wie Teflon oder ein elastomeres Material angeordnet, das bei Aktivierung des Balges 5b gegen die Zwischenwand 3 gedrückt wird und dann dichtet.

In den Fig. 1h und 1i trägt der metallene Balg 5b frontseitig ein flächiges überdeckendes Element bzw. eine Platte oder ein Rahmen 101, die entweder aus einem Kunststoff gefertigt sein kann, oder aber ebenfalls aus Metall bestehen kann. Um wiederum eine gute Abdichtung gegenüber dem Element 3 zu gewährleisten ist vorzugsweise die Platte 101 durch ein elastisches Material 5c, wenigstens in ihrem peripheren Bereich, überdeckt.

Die Fig. 1h zeigt die Dichtungsanordnung im Schnitt, währenddem die Fig. 1i die Anordnung in Obendraufsicht darstellt, woraus insbesondere die allseitig peripher, die Platte 101 überdeckende elastische Dichtung 5c erkennbar ist. Durch die Verwendung eines metallenen Balges 5b ist es möglich, relativ grossflächige Platten 101 zu verwenden, womit ein grossflächiges Abdichten ermöglicht wird, auch bei grossen zu überbrückenden Zwischenräumen.

In Fig. 1k schlussendlich ist erneut eine schlauchartige Dichtung 5 dargestellt, angeordnet auf einer Trägerplatte 103. Wiederum kann die schlauchartige Dichtung 5 direkt auf der Platte aufvulkanisiert sein oder aber mittels eines Klebmaterials 6a auf der Platte angeordnet sein. Die Trägerplatte 103 wird mittels Befestigungen 102, z.B. mittels Schrauben, auf der äusseren Wandung 1 angeordnet, und über Dichtungswülste 5c, bestehend beispielsweise aus einem Elastomeren oder gummiartigen Material abgedichtet werden. Fig. 1k erlaubt ein besonders einfaches Montieren und Auswechseln der Dichtung, wenn diese aufgrund von Abnutzung ersetzt werden muss. Durch den Aufbau an einem Träger, wie einem Halterahmen oder einer Platte kann diese Einheit mit Dichtung als eine Komponente gehandhabt werden, was für die kommerzielle Nutzung wichtig ist. Zudem besteht die Möglichkeit, je nach Bedarf, verschiedene Dichtungen anzuordnen, indem die Trägerplatten 103 jederzeit austauschbar sind.

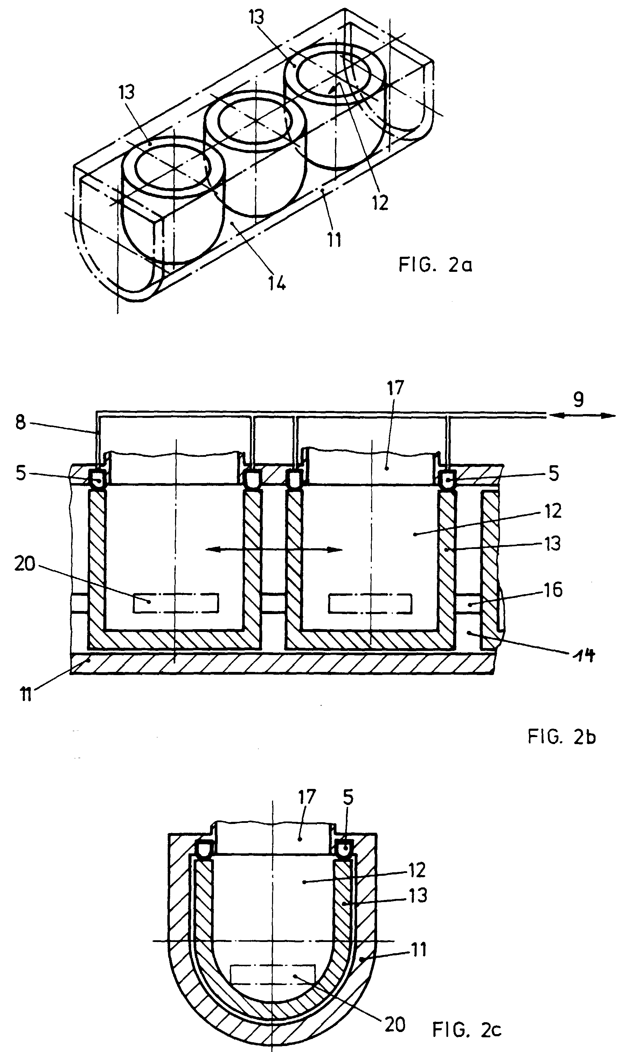

In den Fig. 2a bis 2c ist ein Beispiel einer möglichen erfindungsgemässen Vakuumbearbeitungsanlage dargestellt, umfassend drei verschiedene Bearbeitungsbereiche, wobei ein zu behandelndes Substrat 20 im Inneren 12 einer kammerartigen Aufnahme 13 angeordnet ist. Die kammerartige Aufnahme 13 ist in einer Vakuumbearbeitungsanlage 11 längsverschieblich angeordnet, und zwar zwischen drei verschiedenen Bearbeitungspositionen.

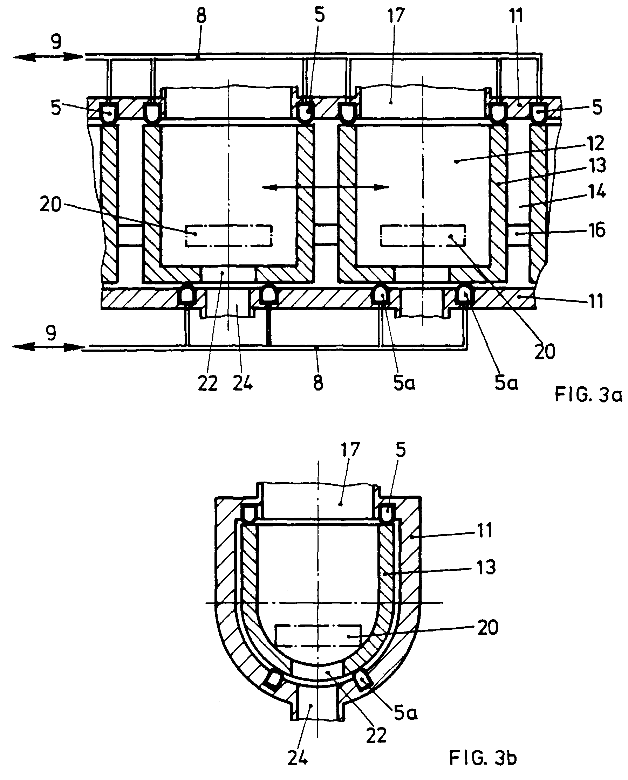

Für die Durchführung eines Bearbeitungsprozesses des Substrates 20 an einer Bearbeitungsstation 17 wird die kammerartige Aufnahme an die entsprechende Position mittels eines Transportsystems 16 bewegt, worauf die Dichtungen 5 mittels durch das Leitungssystem 8 zugeführten Gases oder einer Flüssigkeit aktiviert werden. Durch das "Aufblasen" der Dichtungen 5 stossen dieselben gegen den oberen Rand der kammerartigen Aufnahme 13, womit das Innere 12 der Kammer 13 dicht gegenüber dem Inneren 14 der Anlage 11 abgeschlossen bzw. abgetrennt wird. Die Kammerelemente 13 können je nach Substratgrösse und den gewünschten Abständen zu den Bearbeitungseinrichtungen bzw. abhängig von den gewünschten Prozesseinstellungen verschieden ausgebildet sein. So kann anstelle der in den Fig. 3a bis 3c dargestellten, relativ tiefen Kammer 13 eine flache Platte vorgesehen sein, mit einer kleinen ausgebildeten Vertiefung, in welcher beispielsweise ein flächiges Substrat, wie ein Wafer, gut Platz findet. So ist es beispielsweise auch möglich, das Transportsystem derart auszubilden, dass in diesem selbst eine Kammer mit entsprechender Tiefenausdehnung für die Aufnahme des Substrates vorgesehen werden kann.

Nun kann das Innere 12 der Kammer 13 auf die gewünschten Prozessbedingungen eingestellt werden und der Bearbeitungsprozess durchgeführt werden. Gleichzeitig kann, wenn die Anlagekammer 11 beispielsweise als Zwischenkammer ausgebildet ist, eine neue Kammer 13 geladen bzw. eingeführt werden, ohne den Prozess zu stören. Auch ist es möglich, mehrere Prozesse und/oder auch Einschleusvorgänge nebeneinander wahlweise entkoppelt ablaufen zu lassen. Nach Beendigung des Prozesses werden die Dichtungen 5 wieder deaktiviert und die Kammer 13 an eine weitere Bearbeitungsstation 17 bewegt.

Die Fig. 2b zeigt dabei die Anlage 11 von Fig. 2a im Längsschnitt, währenddem Fig. 2c einen entsprechenden Querschnitt durch die Anlage und die kammerartige Aufnahme 13 zeigt.

In den Fig. 3a und 3b ist eine ähnliche Anlage 11 dargestellt, wobei jedoch zusätzlich die kammerartige Aufnahme 13 an ihrem unteren Bereich eine Oeffnung 22 aufweist, beispielsweise um das Innere 12 der Aufnahme 13 an eine Vakuumpumpe 24 anzuschliessen oder um einen Zugang für Minipulatoren, Messeinrichtungen oder auch zusätzliche Prozessmöglichkeiten zu schaffen. Damit das Innere 12 der Kammer 13 an einer Bearbeitungsstation 17 dicht gegenüber dem Inneren 14 der Anlage 11 abschliessbar ist, müssen zusätzlich auf beiden Seiten der zusätzlichen Oeffnung 22 Dichtungen 5a angeordnet werden, welche wiederum über Leitungen 8 von einem pneumatischen oder hydraulischen System 9 aktiviert werden. Erfindungsgemäss sind auch mehrere solche Oeffnungen realisierbar.

Für die Durchführung des Bearbeitungsprozesses für die Behandlung des Substrates 20 an einer Station 17 wird wiederum das Innere 12 der Aufnahme 13 evakuiert, wobei im gezeigten Beispiel das Evakuieren entgegengesetzt zur eigentlichen Bearbeitungsanordnung erfolgt.

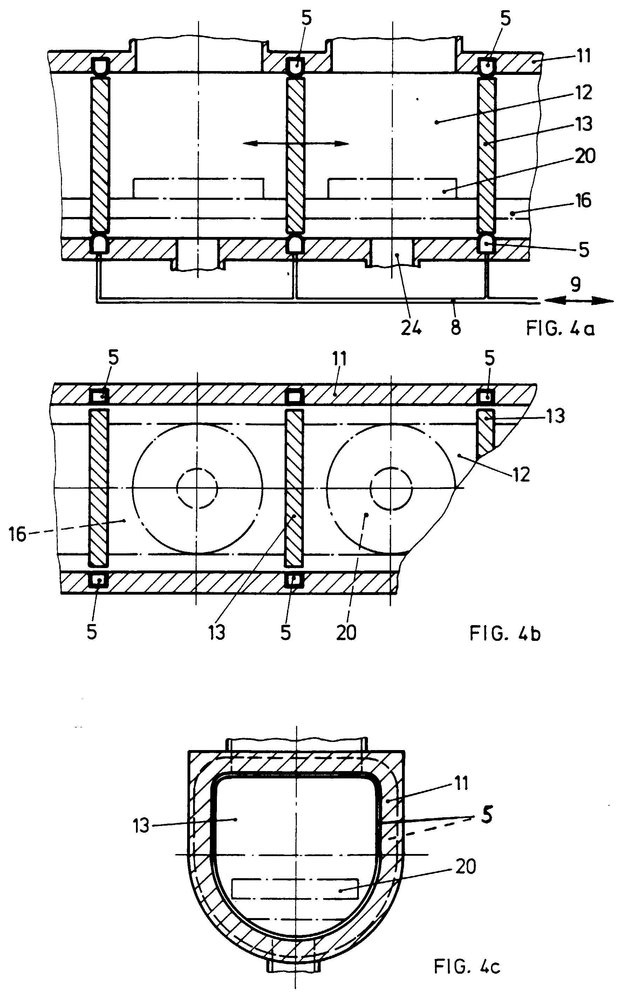

Die Fig. 4a, 4b und 4c zeigen wiederum eine weitere Ausgestaltung einer erfindungsgemässen Vakuumbearbeitungsanlage, wobei Fig. 4a einen Längsschnitt von der Seite gesehen, Fig. 4b einen Längsschnitt von oben gesehen und Fig. 4c die Anlage im Querschnitt darstellen. Die kammerartige Aufnahme 12 ist gemäss der Ausführung von Fig. 4a, 4b und 4c dergestalt, dass sie nur noch querliegende, als verbundenes Transportmittel bildende Trennwände 13 in Längsrichtung gesehen aufweist, verbunden über Verbindungen 16. In Fig. 4 ist die äussere Kammerwand als kanalförmiges Element 11 ausgebildet, wobei die Dichtungen 5 und die Trennwände 13 getrennte Kammern bilden. Diese Funktionsweise kann auch angewendet werden, indem anstelle des kanalförmigen Elementes eine rotationssymmetrische Kammer verwendet wird, in welcher um eine Zentralachse Trennwände dichtend drehbar angeordnet sind. Die Dichtungen 5 können über Leitungen 8 von einem hydraulischen bzw. pneumatischen System 9 aktiviert werden.

Wie bereits unter Bezug auf die Fig. 2a bis 2c angeführt, kann im Falle von dünnen und flächigen Substraten, wie beispielsweise von Wafern, eine entsprechende Kammer bzw. ein Behältnis als Vertiefung in der Transportverbindung 16 angeordnet sein, wobei in diesem Fall auf die Trennwände 13 verzichtet werden kann. Falls die Substrate sehr dünn sind, ist der beim Transport des Substrates zu durchlaufende Spalt bzw. die Oeffnung von einer Kammer zur nächsten derart klein, dass er nur mittels der hydraulisch bzw. pneumatisch aktivierbaren Dichtung 5 überbrückt werden kann. Somit entfällt, wie erwähnt, die Notwendigkeit einer Trennwand 13. Die Transportplatte 16 wird dann direkt gedichtet. In analoger Weise wird dann in der oben erwähnten rotationssymmetrischen Kammer eine drehbare Platte bzw. rotierbare Transportplatte 16 vorgesehen, mit entsprechend darin ausgebildeten Aufnahmen bzw. Kammern mit geringer Tiefe, falls die Substrate flächig sind. Wiederum wird die erwähnte Transportplatte 16 direkt abgedichtet.

Das Grundprinzip der Anlage entspricht demjenigen von den Fig. 2a bis 2c oder 3a bzw. 3b.

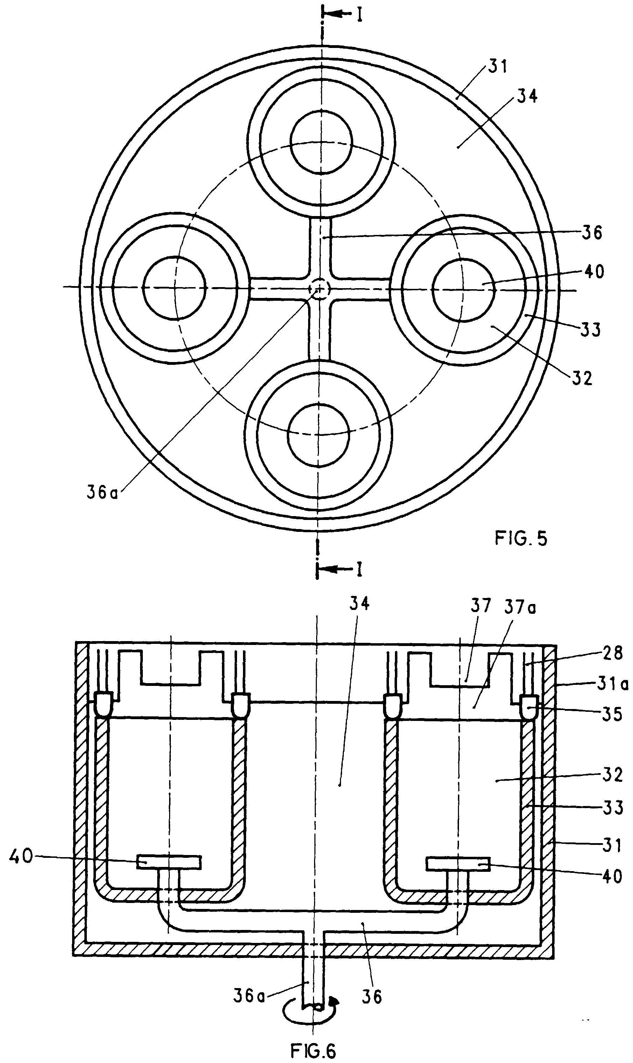

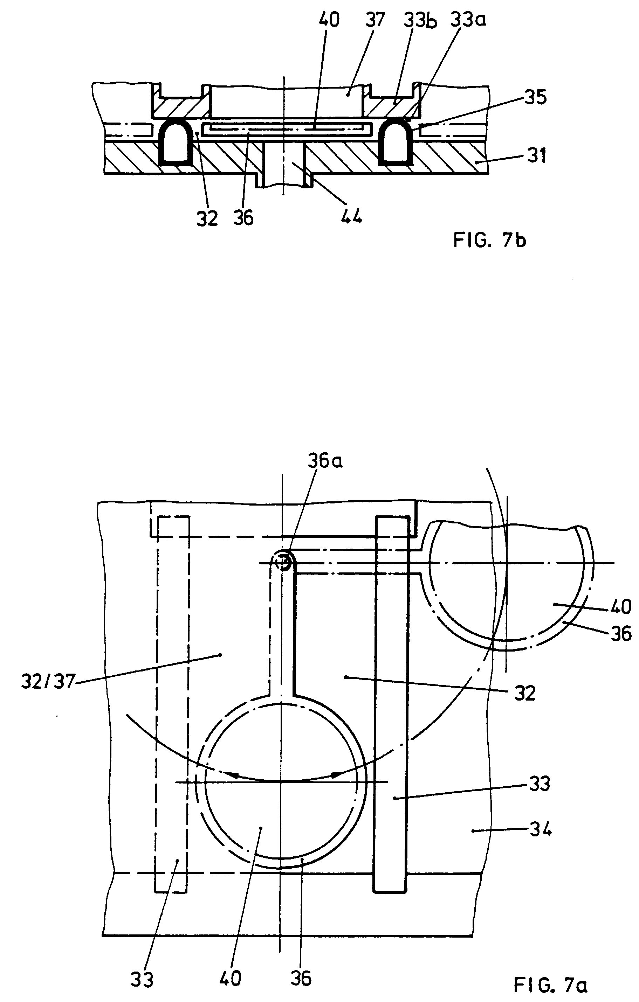

In den Fig. 5 und 6 ist, im Gegensatz zu den vorherigen Beispielen, schematisch eine Vakuumbearbeitungsanlage als Rundlaufanordnung dargestellt, in welcher vier voneinander getrennte Bearbeitungsprozesse durchgeführt werden können.

Dabei zeigt Fig. 5 die Anlage von oben gesehen, wobei die eigentlichen Bearbeitungsanordnungen in den einzelnen Stationen entfernt wurden, damit der Blick ins Innere der Anlage frei ist.

In Fig. 6 ist dieselbe Anlage entlang der Linie I-I im Querschnitt dargestellt.

Innerhalb einer äusseren Anlagekammer 31 sind auf einem rotierbaren Transportkreuz 36 vier kammerartige Aufnahmen 33 angeordnet, je im Inneren 32 miteinschliessend ein zu behandelndes Substrat 40. Im Deckbereich 31a der Vakuumanlage sind vier unterschiedliche Bearbeitungsanordnungen 37 angeordnet für die Durchführung von beispielsweise Beschichtungs- bzw. Aetzprozessen am Substrat 40. Um die jeweiligen vier Prozesskammern 37a von der Zwischenkammer 34 der Anlage 31 abzutrennen, sind pneumatisch oder hydraulisch aktivierbare Dichtungen 35 vorgesehen, welche am oberen Rand der Aufnahme 33 einen dichten Abschluss ermöglichen. Für die Durchführung der Prozesse werden nun diese Dichtungen 35 aktiviert und das Innere 37a der entsprechenden Prozesskammer mittels geeigneter Mittel evakuiert, wobei auf deren Darstellung aus Uebersichtlichkeitsgründen verzichtet wird.

Nun erfolgt die Behandlung des Substrates 40 mittels der jeweiligen Bearbeitungsanordnungen 37, wobei keine Kontamination durch das Innere 34 der Anlage 31 oder von anderen Bearbeitungskammern möglich ist. Nach Beendigung der jeweiligen Prozesse werden die Dichtungen 35 deaktiviert und die vier Kammern 33 durch das Rotationssystem 36 um 90° geschwenkt. Nun erfolgt eine weitere Bearbeitung der Substrate 40.

Die in den Fig. 5 und 6 dargestellte Vakuumbearbeitungsanlage ist selbstverständlich schematisch sehr vereinfacht dargestellt und lässt sich durch Anbringen einer Eintritts- bzw. Austrittsschleusenanordnung ergänzen. So kann eine der Prozesspositionen, beispielsweise direkt als Schleusenanordnung vorgesehen werden, um Substrate von Atmosphäre her in die Anlage einzubringen.

Auch ist es möglich, weitere Bearbeitungsstationen vorzusehen und die einzelnen Aufnahmen 33 analog den Aufnahmen gezeigt in den Fig. 2 bis 4 andersartig auszugestalten. Auch ist es ohne weiteres möglich, für flache Substrate anstelle der Kammern und des Rotationssystems 36 eine einzelne drehbare Platte mit kleinen Vertiefungen als Substrataufnahmen zu verwenden.

In den Fig. 7a und 7b ist eine weitere Anordnung dargestellt, geeignet für die Verwendung von hydraulisch bzw. pneumatisch aktivierbaren Dichtungen. Diese eignet sich insbesondere für das Beschichten von flächigen bzw. scheibenartigen Substraten, bei deren Oberflächenbehandlung es nicht unbedingt notwendig ist, eine in einer Vakuumbearbeitungsanlage frei verschiebbare Aufnahme bzw. ein offenes Behältnis vorzusehen, in welchem das zu behandelnde Substrat anzuordnen ist.

In Fig. 7a ist von oben gesehen eine in einer Anlage 31 ortsfeste Behandlungskammer 32 dargestellt, umfassend seitliche, fest angeordnete Begrenzungswandungen 33b. In der Bearbeitungskammer 32 ist eine hebelartige, um eine Achse 36a schwenkbare Transportunterlage 36 angeordnet, welche in die und aus der Behandlungskammer 32 schwenkbar ist. Die Schwenkbewegung erfolgt durch einen Spalt 33a, welcher, wie aus Fig. 7b ersichtlich, unterhalb der seitlichen Begrenzungswandung 33b ausgebildet ist.

Wie ebenfalls aus Fig. 7b erkennbar, ist dieser Spalt 33a mittels einer pneumatisch oder hydraulisch aktivierbaren Dichtung 35 abschliessbar.

Für das Einführen des zu behandelnden flächigen oder scheibenartigen Substrates 40 wird die Transportvorrichtung 36 durch den Spalt 33a nach aussen geschwenkt, um das Substrat aufzunehmen. Anschliessend erfolgt die Schwenkbewegung um die Achse 36a in die Behandlungskammer 32. Nun werden die beiden Dichtungen 35 aktiviert, worauf der Spalt 33a dicht verschlossen wird. Darauf ist es möglich, mittels einer Bearbeitungsanordnung im Bearbeitungsraum 37 das flächige Substrat 40 zu behandeln bzw. zu beschichten. Anstelle von schwenkbaren Transportvorrichtungen können selbstverständlich alle Arten von translatorischen Transportvorrichtungen verwendet werden, welche flach gebaut sind.

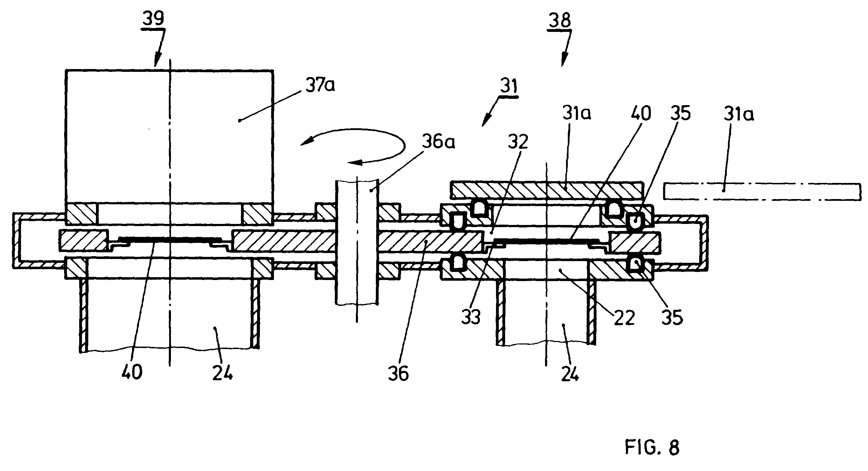

In Fig. 8 ist analog zu Fig. 7 eine Vakuumbearbeitungsanlage dargestellt, für das Bearbeiten von flächigen bzw. scheibenartigen Substraten, wobei analog zur Darstellung von Fig. 5 und Fig. 6 das bzw. die zu behandelnden flächigen Substrate 40 auf einem Transportmechanismus 36 um eine Rotationsachse 36a zwischen mehreren Stationen rotiert werden. Dabei kann es sich, wie in den Fig. 5 und 6, um eine Mehrfachbehandlungsanlage handeln oder aber um eine Vakuumbearbeitungsanlage mit einer Schleusenkammer 38 und einer Vakuumbearbeitungskammer 39. Die Anlage in Fig. 8 ist analog Fig. 6 im Querschnitt dargestellt, da eine entsprechende Obendraufsicht dieser Anlage in etwa Fig. 5 entspricht.

Für das Oeffnen der Einführungs- bzw. Schleusenkammer 31 befindet sich eine Abdeckung 31a in der in Fig. 8 gestrichelt dargestellten Position.

Dadurch kann ein flächiges Substrat 40, wie beispielsweise eine Waferplatte oder eine Linse 40, auf eine Unterlage 33 in einer Aussparung 32 von einem Rotationsmechanismus 36 ein- bzw. aufgelegt werden. Nach Einlegen des Substrates 40 wird der obere Abschluss 31a in die ausgezogen dargestellte Position bewegt und anschliessend die hydraulisch bzw. pneumatisch aktivierbaren Dichtungen 35 aktiviert, womit die Schleusenkammer 38 dicht gegenüber Atmosphäre abgedichtet ist. Durch eine untere Oeffnung 22 und Vakuummittel 24 wird die Schleusenkammer 38 evakuiert. Nach Durchführung der Vakuumierungsoperation in der Schleusenkammer 38 wird nun der Transportmechanismus 36 um 90° bzw. 180° um die zentrale Achse 36a rotiert. Um 90° dann, falls sich an dieser Stelle eine Bearbeitungskammer befindet, um 180° dann, falls, wie in Fig. 8 dargestellt, nur eine Bearbeitungskammer 39 in der Vakuumanlage 31 vorhanden ist. In der Bearbeitungskammer 39 kann nun das Substrat 40 durch eine im Bearbeitungsraum 37a angeordnete Bearbeitungseinrichtung, wie beispielsweise eine Sputter-Vorrichtung, beschichtet werden. Auf der gegenüberliegenden Seite weist die Bearbeitungskammer 39 ebenfalls eine Vakuumierungseinrichtung 24 auf, um den Bearbeitungsraum 37a unter Hochvakuum zu halten. Je nach Ausgestaltung der Vakuumbearbeitungsanlage 31 können in der Bearbeitungskammer 39 ebenfalls pneumatisch oder hydraulisch aktivierbare Dichtungen angeordnet sein, wobei jedoch bei nur einer Bearbeitungskammer 39 auf die Anordnung dieser Dichtungen verzichtet werden kann. Nach Durchführung der Bearbeitungsoperation in der Kammer 39 wird die Transporteinrichtung 36 erneut um 180° rotiert, worauf das Substrat 40 aus der Schleusenkammer 38 wieder entfernt werden kann.

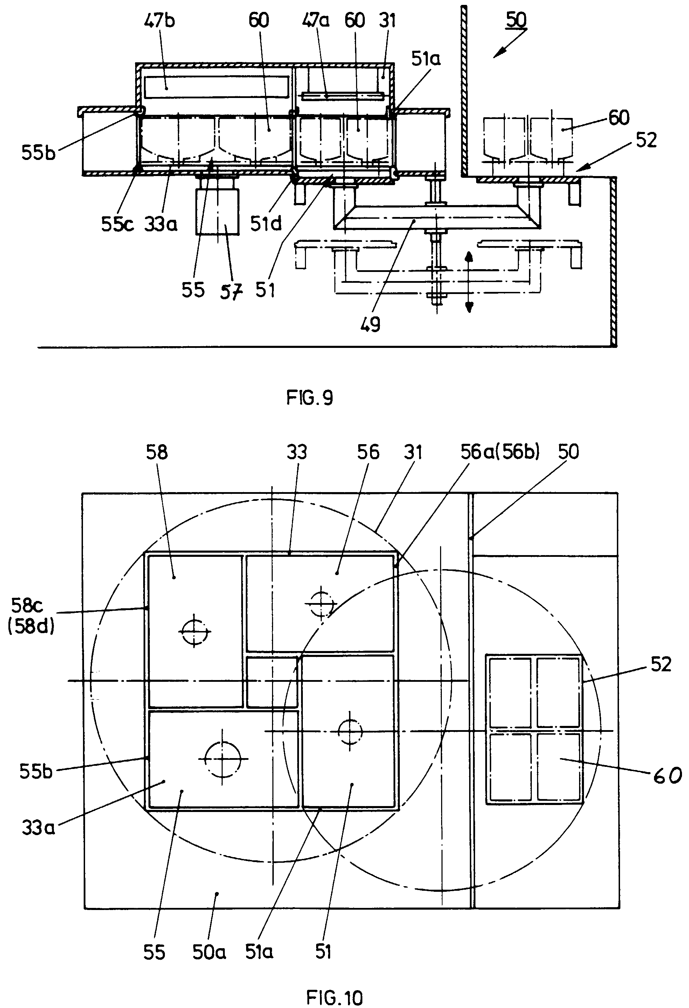

In den Fig. 9 und 10 ist eine Anlage für die Durchführung von mehreren Bearbeitungsvorgängen dargestellt. Dabei kann es sich beispielsweise um eine Anlage zum Aufbringen einer korrosionsbeständigen flexionsschicht auf Automobilscheinwerfern handeln. Die beispielsweise dazu notwendigen Behandlungsschritte sind:

Einschleusen der Scheinwerfer in die Vakuumbeschichtungsanlage, Vorbehandlung, Metallisierung, Anbringen einer Schutzschicht und Nachbehandlung.

Die Vakuumumgebung in all diesen Behandlungs- bzw. Bearbeitungsschritten ist stark unterschiedlich, so dass eine strikte Trennung der verschiedenen Prozessbereiche erforderlich ist.

Die entsprechende Anlage ist in Fig. 9 in seitlicher Querschnittsanordnung dargestellt und in Fig. 10 im Schnitt von oben gesehen.

Die zu behandelnden Substrate 60, bei denen es sich beispielsweise um Automobilscheinwerfer handeln kann, werden von einer Anfangsposition 52 mittels eines Transportmechanismus nach unten abgesenkt und in die Anlage 50 eingeführt. Durch anschliessende Rotationsbewegung werden die Substrate 60 unterhalb die Position 51 um 180° gedreht und durch anschliessende Aufwärtsbewegung des Transportmittels 49 in die eigentliche Hauptkammer 31 der Vakuumbearbeitungsanlage eingeführt. Durch Betätigen von Dichtungen 51a und 51d wird in Position 51 eine erste Bearbeitungskammer oder Schleusenkammer getrennt evakuierbar erzeugt, in welcher, falls vorhanden, mittels einer Bearbeitungsvorrichtung 47a ein erster Bearbeitungsprozess, wie oben angeführt, an den Scheinwerfern durchgeführt werden kann. Position 51 kann aber auch eine reine Schleusenkammer zum Ein- bzw. Ausführen der Substrate sein.

Nach Beendigung dieses ersten Bearbeitungsprozesses in der Position 51 werden die Dichtungen 51a und 51d entspannt und die vier behandelten Scheinwerfer auf einer gemeinsamen Unterlage um 90°, beispielsweise im Gegenuhrzeigersinn, rotiert, worauf analog in der Position 56 ein weiterer Bearbeitungsprozess an den Scheinwerfern ausgeführt werden kann. Nach erneuter Rotation um 90° wird ein weiterer Prozess in Position 58 ausgeführt.

In Fig. 9 sind schliesslich die Scheinwerfer 60 in Position 55 erkennbar, wo mittels Dichtungen 55b und 55c erneut ein vollständig dichtes Abtrennen dieser Behandlungskammer 55 möglich ist. Mittels einer Bearbeitungsanordnung 47b wird wiederum ein weiterer Bearbeitungsprozess an den Scheinwerfern 60 ausgeführt.

Wenn nun die Scheinwerfer vollständig behandelt sind, werden sie in die ursprüngliche Position 51 zurückgeschwenkt und mittels des Transportmechanismus 49 durch Absenken, Rotation um 180° und erneutem Heben in die Position 52 aus der Anlage 50 transportiert. Praktisch werden die gezeigten Positionen 51, 56, 58 und 55 im Takt betrieben, wobei insbesondere die Abdichtung der einzelnen Kammern jeweils durch gleichzeitiges Betätigen der acht Dichtungen 51a, d; 56a, b; 58c, d und 55b, c erfolgt. Nun können die fertig behandelten Scheinwerfer 60 von der Unterlage entfernt werden, um entweder einer weiteren Behandlung zugeführt zu werden oder aber, um beispielsweise an einem Automobil eingebaut zu werden. Für bestimmte Arbeiten, wie beispielsweise Unterhaltsarbeiten, können auf einfache Weise auch nur Teilbereiche der Anlage durch entsprechendes Schalten der Dichtungen individuell behandelt bzw. belüftet werden.

Selbstverständlich handelt es sich bei der Darstellung in Fig. 9 und Fig. 10 um eine vereinfachte schematische Darstellung, und auf an sich bekannte Details, wie beispielsweise das Anbringen von Vakuumpumpen, das Anordnen von Zuführ- und Abführleitungen des pneumatischen oder hydraulischen Mediums etc., wurde aus Uebersichtlichkeitsgründen verzichtet. Vielmehr geht es darum, den erfindungswesentlichen Gedanken anhand dieses Beispiels praxisnahe zu erläutern. Ebenso können die hier als Kammern ausgebildeten Aufnahmebereiche für die Substrate bei hinreichend flachen Substraten analog zur Anlage in Fig. 8 die Form einer Platte mit Ausnehmungen zum Einlegen der Substrate annehmen.

In den in den Fig. 2 bis 10 dargestellten Anordnungen ist es möglich, irgendwelche Beschichtungs- bzw. Bearbeitungsprozesse an Substraten oder Werkstücken durchzuführen. Insbesondere eignet sich die erfinderische Idee für die Durchführung von CVD-Verfahren, PVD-Prozessen etc. - kurz gesagt, für all diejenigen Oberflächenbehandlungsprozesse bzw. Aetz- oder Beschichtungsprozesse, wo unter Vakuum bzw. Hochvakuum gearbeitet werden muss.

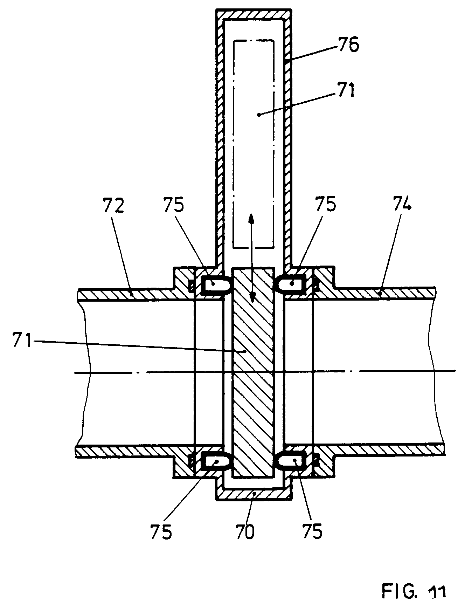

In Fig. 11 ist ein Ventil 70 dargestellt, welches vorgesehen ist zum Verschliessen des Verbindungsdurchganges zwischen den beiden Rohranschlüssen 72 und 74. Ein schieber- oder plattenartiges Element 71 wird zum Verschliessen oder Oeffnen des genannten Durchganges zwischen der ausgezogen dargestellten geschlossenen Position und der gestrichelt dargestellten Position bewegt. Für das Zurückziehen des platten- oder schieberartigen Elementes 71 ist eine kammerartige Auskragung 76 am Ventil 70 angeordnet. Für das Verschliessen des Ventils gelangt das schieber- oder plattenartige Element 71 in den offenen Durchgang zwischen den beiden Rohren 72 und 74, wobei das Verschieben von der gestrichelt dargestellten Position in die ausgezogen dargestellte Position erfolgen kann, da die pneumatisch oder hydraulisch aktivierbaren Dichtungen 75 deaktiviert und somit zurückgezogen sind und somit keine seitliche Reibung am Element 71 auftritt. Sobald das Element 71 vollständig den Durchgang zwischen den beiden Anschlüssen 72 und 74 verschliesst, werden zum dichten Abschliessen die Dichtungen 75 aktiviert. Der Vorteil des in Fig. 11 dargestellten Ventils liegt einerseits darin, dass das Ventilelement 71 nur in einer einzigen Richtung bewegt werden muss und somit eine Anpressbewegung bzw. ein Anpressmechanismus entfällt, und zudem das Verschieben von der offenen in die Schliessposition des Elementes 71 mit geringem Kraftaufwand erfolgen kann, da beim Bewegen des Ventilelementes 71 keinerlei Reibung auftritt. Das in Fig. 11 dargestellte Ventil kann einerseits in sämtlichen vorab dargestellten Vakuumbearbeitungsanlagen verwendet werden, ist aber grundsätzlich universell verwendbar, d.h. auch für das Abtrennen bzw. Verschliessen von Flüssigkeitsleitungen, Gasleitungen unter Atmosphäre etc.

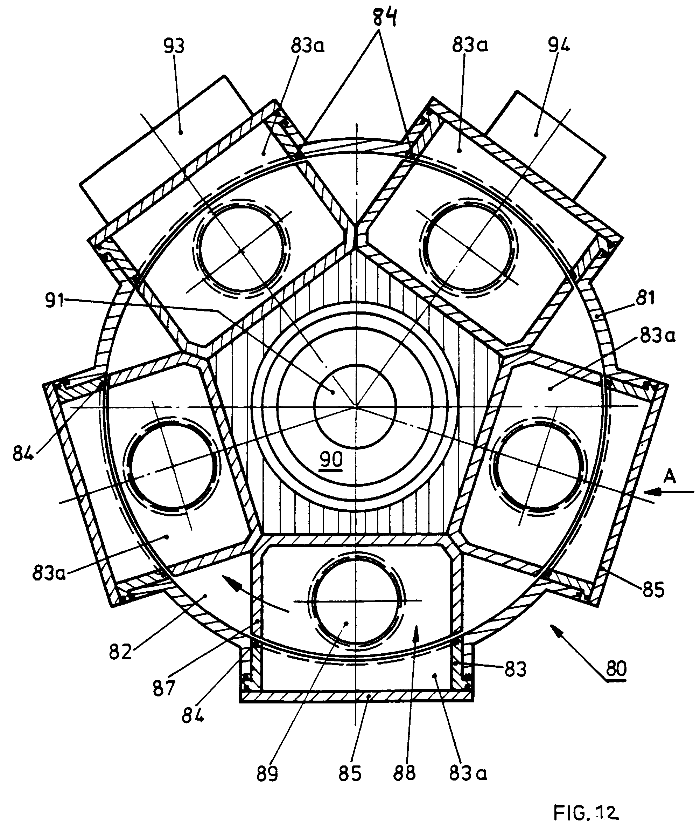

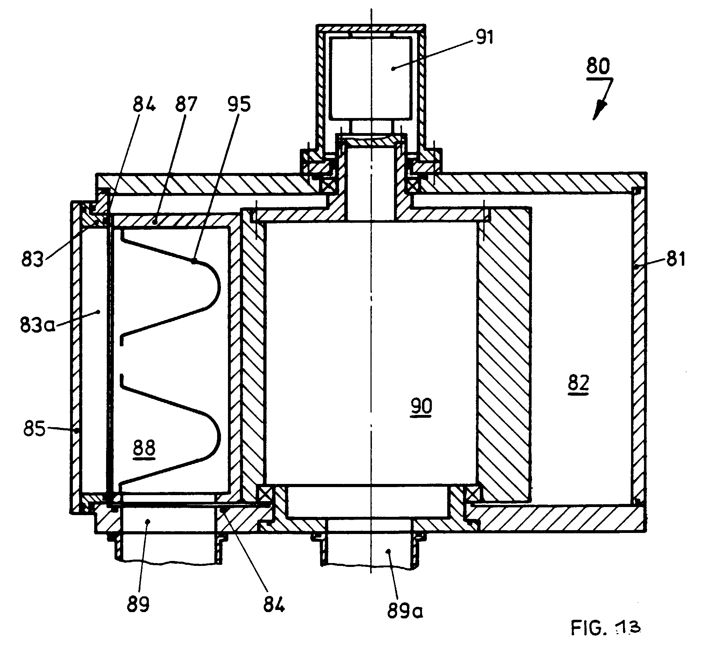

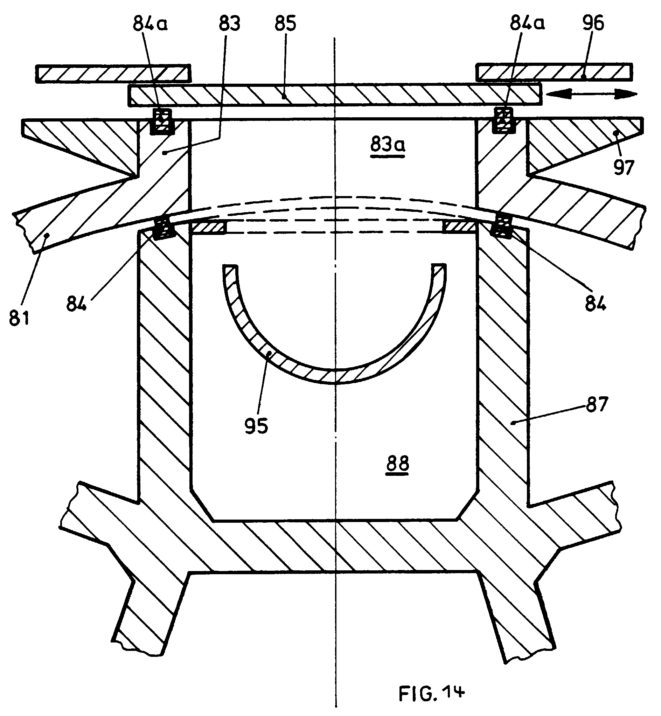

In den Fig. 12 bis 14 ist eine weitere bevorzugte erfindungsgemässe Ausführungsvariante einer Bearbeitungsanlage dargestellt. Dabei zeigt Fig. 12 die Anlage im Querschnitt von oben gesehen, Fig. 13 die Anlage im Querschnitt von der Seite gesehen und Fig. 14 einen Ausschnitt aus Fig. 12, darstellend eine einzelne Bearbeitungskammer, bzw. eine Schleusenanordnung.

Die Bearbeitungsanlage 80 ist zylinderförmig ausgebildet, umfassend einen äusseren, fest angeordneten Zylindermantel 81 und einen inneren, um die Achse rotierbaren Teil 82, umfassend die einzelnen Kammern 88, für das Anordnen der zu bearbeitenden Substrate, wie beispielsweise von Reflektoren 95. Wie aus Fig. 12 erkennbar, sind fünf derartige Kammern 88 angeordnet, die durch jeweilige Wandungen 87 gebildet werden. Diese Kammern sind sternförmig bzw. peripher entlang der Zylinderwandung 81 angeordnet, wobei deren Oeffnungen nach aussen hin gerichtet, ausgebildet sind. Die Oeffnungen der Kammern sind in der jeweiligen Bearbeitungsposition gegen entsprechende Bearbeitungsräume 83a gerichtet, welche einerseits durch seitliche Wandungen 83 gebildet werden sowie in Schleusenposition einer peripher nach aussen gerichteten, wieder entfernbaren Ueberdeckung 85, wobei die Wandungen der Kammern und Bearbeitungsräumen derart aufeinander abgestimmt sind, dass in den jeweiligen Bearbeitungspositionen diese genau aufeinanderpassen. In der Prozessposition können beispielsweise die Bearbeitungsräume 83a mit einer Bearbeitungseinrichtung 93, 94 versehen sein, wie beispielsweise mit Zerstäubungsquellen und/oder Aetzvorrichtungen. Wahlweise kann die Anlage je nach Bedarf mit der entsprechenden Anzahl Bearbeitungseinrichtungen bestückt sein. Werden einzelne Kammern nicht benötigt, können diese mit fest angeflanschten Abdeckungen 85 versehen werden. Um in den jeweiligen Positionen ein Bearbeiten des Substrates zu ermöglichen und das dazu notwendige Abdichten des Bearbeitungsraumes gegenüber aussen zu gewährleisten, sind weiter hydraulisch bzw. pneumatisch aktivierbare Dichtungen 84 vorgesehen, die bei Rotation der Prozesskammeraufnahmen in zurückgezogenem Zustand sind und während des Bearbeitungsprozesses im aktivierten, ausgelenkten Zustand. Für das Bearbeiten eines Substrates, wie beispielsweise eines Reflektors 95, kann beispielsweise in Position A die Ueberdeckung 85 eines fest angeordneten Bearbeitungsraumes entfernt werden und das Substrat in die entsprechend, in Position angeordnete Kammer eingegeben werden. Anschliessend wird die Ueberdeckung 85 dichtend befestigt, und die Kammer anschliessend evakuiert, um die bei der Eingabe des Substrates in die Prozesskammer gelangte Luft zu entfernen. Dies kann beispielsweise durch am Boden der zylinderartigen Bearbeitungsanlage angeordnete Pumpstutzen 89 erfolgen. Nun werden die Dichtungen 84 in der gesamten Anlage deaktiviert und der innere rotierbare Teil 82, beispielsweise im Uhrzeigersinn, so lange gedreht, bis jede Prozesskammmer an die nächste Station gelangt ist. Anschliessend werden die aktivierbaren Dichtungen 84 erneut aktiviert und an den Bearbeitungsstationen die einzelnen Prozesskammern über die Pumpstutzen 89 evakuiert. Die Rotation des inneren rotierbaren Teils 82 des Zylinders erfolgt beispielsweise über einen Motor 91.

An den verschiedenen Bearbeitungsstationen können entweder die für die Bearbeitung notwendigen Einrichtungen 93, 94 innerhalb des Bearbeitungsraumes 83a angeordnet sein, oder an den Bearbeitungsraum 83a angeflanscht werden. Damit die gesamte Anlage selbst ebenfalls evakuierbar ist, ist im übrigen mittig ein weiterer Pumpstutzen 89a angeordnet, über welchen ebenfalls der mittige Raum 90 des Zylinders evakuiert werden kann.

Fig. 14 zeigt eine einzelne Kammer gemäss der Darstellung von Fig. 12 wobei die Ueberdeckung 85 eines Prozessraumes 83a in einer speziellen Ausführung als Schleusenvorrichtung dargestellt ist. Für den Ein- und Ausschleusvorgang der Substrate können die beiden äusseren aktivierbaren Dichtungen 84a deaktiviert werden, und die schieberartig ausgebildete Ueberdekkung 85 kann in den Führungen 96 bzw. 97 in Pfeilrichtung verschoben werden. Sobald der Vorgang ausgeführt ist, wird die Ueberdeckung 85 wieder in die dargestellte Position verschoben, und die beiden äusseren aktivierbaren Dichtungen 84a werden erneut aktiviert, worauf der Bearbeitungsraum 88 nach aussen dicht abgeschlossen ist. Hierbei handelt es sich natürlich nicht um zwei einzelne Dichtungen 84a, sondern um eine ringförmig geschlossene Dichtung, welche eine allseitige dichtende Verbindung zwischen der Bearbeitungsraumwandung 83 und der Ueberdeckung 85 gewährleistet.

Die Anlage, dargestellt in den Fig. 12 bis 14, kann selbstverständlich auch invers betrieben werden, indem die mittig angeordneten Kammern fest sind und der Zylindermantel um die mittig, fest angeordnete Anordnung relativ rotiert wird. Zudem können selbstverständlich auch übliche Schleusenanordnungen mit bekannten Ventilanordnungen ohne pneumatisch aktive Dichtungen verwendet werden.

## Patentansprüche

1. Vakuumbearbeitungsanlage für das Oberflächenbehandeln von Substraten und Werkstücken mit mindestens zwei Stationen, wobei mindestens eine Station eine Bearbeitungsstation ist, gekennzeichnet durch:
- einen Tansport- bzw. Bewegungsmechanismus, um die zu behandelnden Substrate oder Werkstücke in die Anlage einzuführen und/oder in der Anlage zwischen Stationen zu transportieren,
- eine oder mehrere kammerartige Aufnahmen (12, 32, 88) bzw. wenigstens einseitig offene Behältnisse für die Aufnahme von Substraten oder Werkstücken (20, 40, 60, 95), welche mittels des Transportmechanismus zwischen den Stationen verschiebbar bzw. austauschbar angeordnet sind,
- eine oder mehrere pneumatisch oder hydraulisch aktivierbare Dichtung(en) (5; 35; 51a,d; 55b,c; 56a,b; 58c,d; 65, 84), wobei die Dichtung(en), schlauch-, balg-, ballon- oder membranartig ist (sind), deren Oberfläche(n) durch Einführen von Gas oder Flüssigkeit in den Kern in das Innere bzw. an eine Seitenfläche der Dichtung(en) in Richtung gegen die Kammerwandungen bzw. Behältniswandungen (12, 32, 88) dehnbar vergrösserbar ist (sind), wobei die Dichtungen an einem Teil oder an allen Stationen angeordnet sind, um die kammerartigen Aufnahmen bzw. Behältnisse in einer jeweiligen Position an einer Station für die Durchführung eines Bearbeitungsprozesses am oder an Substrat(en) oder Werkstück(en) dichtend abzutrennen bzw. abzuschliessen.

2. Vakuumbearbeitungsanlage für das Oberflächenbehandeln von Substraten und Werkstücken, mit mindestens zwei Stationen, wobei mindestens eine Station eine Bearbeitungsstation ist; gekennzeichnet durch:
- einen Transport- bzw. Bewegungsmechanismus, um die zu behandelnden Substrate oder Werkstücke in die Anlage einzuführen und/oder in der Anlage zwischen Stationen zu transportieren,
- eine oder mehrere flächige Transportunterlagen oder Transportplatten (33, 36), um die Gegenstände in die mindestens eine oder zwischen mindestens zwei Bearbeitungsstationen zu verschieben,
- eine oder mehrere pneumatisch oder hydraulisch aktivierbare Dichtung(en) (5, 35), wobei die Dichtung(en) schlauch-, balg-, ballon- oder membranartig ist (sind), deren Oberfläche(n) durch Einführen von Gas oder Flüssigkeit in den Kern in das Innere bzw. an eine Seitenfläche der Dichtung(en) in Richtung gegen die Transportunterlage (33, 36) oder gegen fest angeordnete Begrenzungswandungen (33b) der Station dehnbar vergrösserbar ist (sind), für das dichte Abtrennen der Stationen, für die Durchführung eines Behandlungsprozesses am oder an Substrat(en) oder Werkstück(en), deren Ausdehnungsweg bzw. Hub derart ist, dass in zurückgezogenem Zustand die Transportunterlagen bzw. Transportplatten frei in oder aus einer Bearbeitungsstation verschiebbar sind, für die Durchführung des Bearbeitungsvorganges in einer Station, jedoch die Transportunterlage bzw. Transportplatte für die Durchführung eines Bearbeitungsprozesses dichtend abtrennbar bzw. abschliessbar ist (sind).

3. Vakuumbearbeitungsanlage nach einem der Ansprüche 1 oder 2, dadurch gekennzeichnet, dass die Dichtung aus einem elastischen und/oder dehnbaren Material besteht, wie einem natürlichen oder synthetischen Kautschuk, einem dehnbaren oder plastischen Kunststoffmaterial bzw. einem Elastomer-Material.

4. Vakuumbearbeitungsanlage nach einem der Ansprüche 1-3, dadurch gekennzeichnet, dass die Dichtung aus einem der nachfolgenden Materialien gefertigt ist:
Butadien-Polymerisat, einem Butadien-Styrol Copolymeren, Silikon, Polyurethan, einem Elastomeren, wie insbesondere einem Fluorelastomeren und/oder einem elastischen Thermoplasten, wie Polyurethan oder elastomeres Polyamid.

5. Vakuumbearbeitungsanlage nach einem der Ansprüche 1-3, dadurch gekennzeichnet, dass als Dichtungen Metallschläuche, Membrane oder metallene Bälge vorgesehen sind, wobei letztere vorzugsweise an den Dichtflächen mit einem elastischen Kunststoff oder einem gummiartigen Material versehen sein können.

6. Vakuumbearbeitungsanlage nach einem der Ansprüche 1-5, dadurch gekennzeichnet, dass mindestens ein äusserer und mindestens ein innerer Anlagebereich vorgesehen sind, wobei am äusseren und/oder inneren Anlagebereich pneumatisch oder hydraulisch aktivierbare Dichtungen vorgesehen sind, um den äusseren und/oder inneren Anlagebereich dicht abzutrennen.

7. Vakuumbearbeitungsanlage nach einem der Ansprüche 1-6, dadurch gekennzeichnet, dass eine Hauptkammer bzw. Verteilkammer vorgesehen ist, innerhalb welcher die zu beschichtenden Substrate bzw. Werkstücke mittels des Transportmechanismus zwischen mindestens zwei Bearbeitungskammern bzw. zwischen einer Schleusenkammer und mindestens einer Bearbeitungskammer gefördert werden, wobei ein Teil oder alle der Bearbeitungskammern bzw. die Schleusenkammer mittels hydraulisch oder pneumatisch aktivierbarer Dichtungen gegenüber der Hauptkammer bzw. Verteilkammer dicht trennbar sind.

8. Vakuumbearbeitungsanlage nach einem der Ansprüche 1 oder 3 - 7, dadurch gekennzeichnet, dass die Anlage zylinderartig ausgebildet ist, und dass mindestens eine Aufnahmekammer bzw. ein Behältnis (88) für die Aufnahme der zu bearbeitenden Substrate (95), entlang des Mantels einer kreis- bzw. zylinderförmigen Verteilkammer (81) angeordnet ist, mit peripher nach aussen gerichteten Kammeröffnungen, welche in den jeweiligen Bearbeitungspositionen gegen die entsprechenden, im Zylindermantel angeordneten Bearbeitungsstationen (83a) gerichtet sind, um die Bearbeitungs- bzw. Prozesskammern zu bilden, welche Aufnahmekammern bzw. Behältnisse oder der Zylindermantel (81) um die Zylindermittelachse rotierbar angeordnet sind, damit die Aufnahmekammern bzw. Behältnisse relativ zum Zylindermantel bewegbar sind, um von einer Bearbeitungsstation zur nächsten bewegt zu werden, wobei an einem Teil oder allen Aufnahmekammern bzw. Behältnissen und/oder Bearbeitungsstationen, pneumatisch oder hydraulisch aktivierbare Dichtungen (84, 84a) vorgesehen sind, um beim Bearbeitungsprozess die Bearbeitungs- bzw. Prozesskammern dichtend abzutrennen.

9. Verwendung der Anlage nach einem der Ansprüche 1 bis 8, für die Bearbeitung von Substraten oder Werkstücken mittels PVD, CVD, Aetzverfahren, thermischer Verfahren und/oder Plasmaverfahren.

10. Verfahren für das dichte Abschliessen bzw. Abtrennen der Vakuumbearbeitungsanlage nach einem der Ansprüche 1 bis 8, oder Teilen davon, dadurch gekennzeichnet, dass die eine oder die mehreren hydraulisch oder pneumatisch aktivierbaren Dichtungen durch Einführen von Gas oder Flüssigkeit ins Innere oder den Kern der Dichtung bzw. an eine Seitenfläche der Membran derart aktiviert werden, dass deren Oberfläche derart vergrössert wird, dass zwischen dem Anlageinneren oder Teilbereichen davon und der jeweiligen Umgebung davon kommunizierende Oeffnungen dicht verschlossen werden.

11. Verfahren nach Anspruch 10 für das dichte Abschliessen bzw. Abtrennen von mindestens einer Bearbeitungsstation und/oder von einer Schleusenkammer in der Vakuumbearbeitungsanlage für die Durchführung getrennter Bearbeitungsprozesse an den Substraten oder Werkstücken, dadurch gekennzeichnet, dass wenigstens an einem Teil der Station(en) oder der Kammer hydraulisch bzw. pneumatisch aktivierbare Dichtungen vorgesehen sind, welche während der Durchführung der Prozesse aktiviert werden, um die jeweilige Station oder Kammer dicht abzuschliessen, und die deaktiviert bzw. zurückgezogen werden, um ein Verschieben der Substrate bzw. Werkstücke zwischen den Stationen und/oder der Kammer und einer Station zu ermöglichen.

12. Verfahren nach einem der Ansprüche 10 oder 11, dadurch gekennzeichnet, dass zum Abschliessen und Wiederöffnen der Anlage bzw. Teilbereichen davon oder von Bearbeitungsstationen und/oder einer Schleusenkammer Ventile mit einem platten-, schieber- oder tellerartigen Element vorgesehen sind, wobei zum dichten Abschliessen das jeweilige platten-, schieber- oder tellerartige Element des Ventils geschlossen wird und anschliessend entlang einer Schliesskontur des Elementes am Ventil eine hydraulisch oder pneumatisch aktivierbare Dichtung derart betätigt wird, dass durch die an der jeweiligen Kontur dichtend anliegende aktivierte Dichtung ein vollständig dichter Abschluss bzw. eine dichte Trennung bewerkstelligt wird.

## Claims

1. Vacuum processing system for surface treatment of substrates and workpieces with at least two stations, where at least one station is a processing station, characterized by:
- a transport or movement mechanism in order to introduce the substrates or workpieces to be treated into the system and/or transport these in the system between stations,
- one or more chamber-like recesses (12, 32, 88) or containers open on at least one side to hold substrates or workpieces (20, 40, 60, 95) which are arranged to be moved or exchanged between the stations by means of the transport mechanism,
- one or more pneumatically or hydraulically activatable seal(s) (5; 35; 51a,d; 55b,c; 56a,b; 58c,d; 65, 84), where the seal(s) is (are) hose, bellows, balloon or membrane-like, the surface(s) of which can be enlarged expandably in the direction against the chamber walls or container walls (12, 32, 88) by the introduction of gas or fluid into the core in the inside or on a side surface of the seal(s), where the seals are arranged on some or all stations in order to separate or close tightly the chamber-like recesses or containers in any position at a station for the performance of a treatment process on the substrate(s) or workpiece(s).

2. Vacuum processing system for surface treatment of substrates and workpieces with at least two stations, where at least one station is a processing station, characterized by:
- a transport or movement mechanism in order to introduce the substrates or workpieces to be treated into the system and/or transport these in the system between stations,
- one or more tabular transport supports or transport plates (33, 36) in order to move the objects into at least one or between at least two processing stations,
- one or more pneumatically or hydraulically activatable seal(s) (5, 35), where the seal(s) is (are) hose, bellows, balloon or membrane-like, the surface(s) of which can be enlarged expandably in the direction against the transport support (33, 36) or against firmly arranged limiting walls (33b) of the station by the introduction of gas or fluid into the core in the inside or on a side surface of the seal(s), for tight separation of the stations for the performance of a treatment process on the substrate(s) or workpiece(s), the expansion route or stroke of which is such that in the retracted state the transport supports or transport plates can be moved freely into or out of a processing station for the performance of the treatment process in a station, but the transport support or transport plate can be separated or closed tightly for the performance of a treatment process.

3. Vacuum processing system according to any of claims 1 or 2, characterized in that the seal consists of an elastic and/or expandable material such as a natural or synthetic rubber, an expandable or plastic synthetic material or an elastomer material.

4. Vacuum processing system according to any of claims 1 to 3, characterized in that the seal is made of one of the following materials:
butadiene polymerisate, a butadiene-styrene copolymer, silicon, polyurethane, an elastomer, in particular a fluoride elastomer, and/or an elastic thermoplastic such as polyurethane or elastomer polyamide.

5. Vacuum processing system according to any of claims 1 to 3, characterized in that as seals, metal hoses, membranes or metal bellows are provided, where the latter can preferably be fitted with an elastic plastic or a rubber-like material on the contact surfaces.

6. Vacuum processing system according to any of claims 1 to 5, characterized in that at least one outer and at least one inner system area are provided where on the outer and/or inner system area are provided pneumatically or hydraulically activatable seals in order to separate tightly the outer and/or inner system area.

7. Vacuum processing system according to any of claims 1 to 6, characterized in that a main chamber or distribution chamber is provided within which the substrates or workpieces to be coated can be transported by means of the transport mechanism between at least two processing chambers or between a lock chamber and at least one processing chamber, where some or all of the processing chambers or the lock chamber can be separated tightly from the main chamber or distribution chamber by means of hydraulically or pneumatically activatable seals.

8. Vacuum processing system according to any of claims 1 or 3 to 7, characterized in that the system is designed as a cylinder and that at least one holding chamber or container (88) to hold the substrate to be treated (95) is arranged along the casing of a circular or cylindrical distribution chamber (81) with chamber openings directed peripherally outwards which, in the relevant processing position, are directed against the corresponding processing stations (83a) arranged in the cylinder casing in order to form the treatment or process chambers, where the said holding chambers or containers or the cylinder casing (81) are arranged rotatably about the cylinder centre axis so that the holding chambers or containers can move relative to the cylinder casing in order to be moved from one processing station to the next, where on some or all holding chambers or containers and/or processing stations are provided pneumatically or hydraulically activatable seals (84, 84a) in order to separate tightly the treatment or process chambers during the treatment process.

9. Use of the system according to any of claims 1 to 8 for processing substrates or workpieces by means of PVD, CVD, etching process, thermal process and/or plasma process.

10. Process for tight sealing or separation of the vacuum processing system according to any of claims 1 to 8, or parts thereof, characterized in that one or more hydraulically or pneumatically activatable seals are activated by the introduction of gas or fluid into the inside or the core of the seal or on a side surface of the membrane such that its surface is enlarged such that openings communicating between the system interior or part areas thereof and the surrounding environment can be tightly sealed.

11. Process according to claim 10 for tightly sealing or separating at least one processing station and/or a lock chamber in the vacuum processing system for the performance of separate treatment processes on the substrates or workpieces, characterized in that at least on some of the stations or the chamber are provided hydraulically or pneumatically activatable seals which are activated during performance of the process in order to seal tightly the relevant station or chamber and which are deactivated or retracted in order to allow movement of the substrates or workpieces between the stations and/or the chamber and a station.

12. Process according to any of claims 10 or 11, characterized in that to close and reopen the system or part areas thereof or processing stations and/or a lock chamber, valves are provided with a disc, slide or plate-like element where for tight sealing the relevant disc, slide or plate-like element of the valve is closed and then a hydraulically or pneumatically activatable seal is activated along a closing contour of the element on the valve such that a completely sealed closure or tight separation is achieved by the activated seal lying closely against the relevant contour.

## Revendications

1. Installation de traitement sous vide pour le traitement superficiel de substrats et de pièces, comportant au moins deux postes dont l'un au moins est un poste de traitement, caractérisée par :
- un mécanisme de transport ou de mouvement destiné à amener les substrats ou les pièces à traiter dans l'installation et/ou à les transporter dans l'installation entre les postes,
- un ou plusieurs logements en forme de chambres (12, 32, 88) ou récipients ouverts au moins d'un côté, qui sont destinés à recevoir les substrats ou les pièces (20, 40, 60, 95) et qui sont disposés pour pouvoir être déplacés ou échangés entre les postes à l'aide du mécanisme de transport, et
- un ou plusieurs joints d'étanchéité (5 ; 35 ; 51a,d ; 55b,c ; 56a,b ; 58c,d ; 75, 84) aptes à être activés par voie pneumatique ou hydraulique, étant précisé que ces joints d'étanchéité sont conçus comme des tuyaux souples, des soufflets, des ballons ou des membranes dont la surface est apte à augmenter par dilatation en direction des parois de chambres ou de récipients (12, 32, 88) grâce à l'introduction de gaz ou de liquide dans le noyau, à l'intérieur ou contre une surface latérale des joints d'étanchéité, et que les joints d'étanchéité sont disposés sur une partie des postes ou sur tous les postes afin de séparer ou de fermer de façon étanche les logements en forme de chambres ou les récipients dans une position correspondante, dans un poste, en vue du traitement du ou des substrats ou pièces.

2. Installation de traitement sous vide pour le traitement superficiel de substrats et de pièces, comportant au moins deux postes dont l'un au moins est un poste de traitement, caractérisée par :
- un mécanisme de transport ou de mouvement destiné à amener les substrats ou les pièces à traiter dans l'installation et/ou à les transporter dans l'installation entre les postes,
- un ou plusieurs supports de transport plats ou plaques de transport (33, 36) destinés à amener les objets dans le ou les postes de traitement ou à les déplacer entre au moins deux postes de traitement,
- un ou plusieurs joints d'étanchéité (5 ; 35) aptes à être activés par voie pneumatique ou hydraulique, étant précisé que ces joints d'étanchéité sont conçus comme des tuyaux souples, des soufflets, des ballons ou des membranes dont la surface est apte à augmenter par dilatation en direction du support de transport (33, 36) ou de parois de limitation fixes (33b) du poste, afin de séparer de façon étanche les postes et d'effectuer un traitement sur le ou les substrats ou pièces, et dont la course de dilatation est telle que lorsque les joints sont en position rétractée, les supports ou plaques de transport peuvent être déplacés librement dans un poste de traitement ou hors de celui-ci afin d'y être traités, tandis que pour la réalisation d'un traitement dans un poste, le support ou la plaque de transport est apte à être séparé ou fermé de façon étanche.

3. Installation de traitement sous vide selon la revendication 1 ou 2, caractérisée en ce que le joint d'étanchéité se compose d'un matériau élastique et/ou extensible comme un caoutchouc naturel ou synthétique, une matière synthétique extensible ou plastique, ou un matériau élastomère.

4. Installation de traitement sous vide selon l'une des revendications 1 à 3, caractérisée en ce que le joint d'étanchéité est fabriqué à partir de l'un des matériaux suivants :
produit de polymérisation du butadiène, un copolymère de butadiène et de styrène, silicone, polyuréthanne, un élastomère comme, en particulier, un élastomère fluoré et/ou un thermoplastique élastique comme un polyuréthanne ou un polyamide élastomère.

5. Installation de traitement sous vide selon l'une des revendications 1 à 3, caractérisée en ce qu'il est prévu, comme joints d'étanchéité, des tuyaux métalliques, des membranes ou des soufflets métalliques, ces derniers pouvant être pourvus de préférence, sur les surfaces d'étanchéité, d'une matière synthétique élastique ou d'un matériau caoutchouteux.

6. Installation de traitement sous vide selon l'une des revendications 1 à 5, caractérisée en ce qu'il est prévu au moins une zone d'installation extérieure et au moins une zone d'installation intérieure, des joints d'étanchéité aptes à être activés par voie pneumatique ou hydraulique étant prévus au niveau de la zone extérieure et/ou intérieure pour isoler de façon étanche la zone extérieure et/ou intérieure.

7. Installation de traitement sous vide selon l'une des revendications 1 à 6, caractérisée en ce qu'il est prévu une chambre principale ou une chambre de distribution à l'intérieur de laquelle les substrats ou pièces à revêtir sont transportés à l'aide du mécanisme de transport entre au moins deux chambres de traitement ou entre une chambre formant sas et au moins une chambre de traitement, étant précisé qu'une partie des chambres de traitement ou toutes ces chambres ou la chambre formant sas sont aptes à être séparées de façon étanche par rapport à la chambre principale ou à la chambre de distribution grâce à des joints d'étanchéité aptes à être activés par voie hydraulique ou pneumatique.

8. Installation de traitement sous vide selon l'une des revendications 1 ou 3 à 7, caractérisée en ce que l'installation a une forme cylindrique et en ce qu'il est prévu, le long de l'enveloppe d'une chambre de distribution circulaire ou cylindrique (81), au moins une chambre de logement ou un récipient (88) qui est destiné à recevoir les substrats (95) à traiter et qui présente des ouvertures de chambres dirigées vers l'extérieur, à la périphérie, et dirigées, dans les postes de traitement correspondants, vers les postes de traitement correspondants (83a) disposés dans l'enveloppe cylindrique, afin de former les chambres de traitement, lesdits chambres de logement ou récipients ou l'enveloppe cylindrique (81) étant disposés pour pouvoir tourner autour de l'axe central du cylindre afin que les chambres de logement ou les récipients soient mobiles par rapport à l'enveloppe cylindrique pour être déplacés d'un poste de traitement au poste de traitement suivant, étant précisé qu'il est prévu sur une partie des chambres de logement ou des récipients et/ou des postes de traitement ou sur tous ceux-ci des joints d'étanchéité (84, 84a) aptes à être activés par voie pneumatique ou hydraulique pour séparer de façon étanche les chambres de traitement lors du traitement.

9. Utilisation de l'installation selon l'une des revendications 1 à 8 pour le traitement de substrats ou de pièces à l'aide de procédés PVD ou CVD, de procédés de gravure, de procédés thermiques et/ou à plasma.

10. Procédé pour la fermeture ou la séparation étanches de l'installation de traitement sous vide selon l'une des revendications 1 à 8 ou de parties de cette installation, caractérisé en ce que le ou les joints d'étanchéité aptes à être activés par voie hydraulique ou pneumatique, grâce à l'introduction de gaz ou de liquide à l'intérieur du joint d'étanchéité, dans le noyau de celui-ci ou contre une surface latérale de la membrane, sont activés de telle sorte que leur surface augmente au point de fermer de façon étanche des ouvertures de liaison entre l'intérieur de l'installation ou des zones partielles de celle-ci et leur environnement.

11. Procédé selon la revendication 10 pour la fermeture ou la séparation étanches d'au moins un poste de traitement et/ou d'une chambre formant sas, dans une installation de traitement sous vide destinée à la mise en oeuvre d'opérations de traitement séparées, sur les substrats ou les pièces, caractérisé en ce qu'il est prévu, sur une partie au moins du ou des postes ou de la chambre, des joints d'étanchéité aptes à être activés par voie hydraulique ou pneumatique qui sont activés pendant les opérations afin de fermer de façon étanche le poste ou la chambre correspondant, et qui sont désactivés ou rétractés afin de permettre un déplacement des substrats ou des pièces entre les postes et/ou entre la chambre et un poste.

12. Procédé selon la revendication 10 ou 11, caractérisé en ce que pour fermer et rouvrir l'installation ou des zones partielles de celle-ci ou des postes de traitement et/ou une chambre formant sas, on prévoit des soupapes comprenant un élément en forme de plateau, de tiroir ou de disque, étant précisé que pour la fermeture étanche, on ferme l'élément en forme de plateau, de tiroir ou de disque correspondant de la soupape, puis on actionne, le long d'un contour de fermeture de l'élément, sur la soupape, un joint d'étanchéité apte à être activé par voie hydraulique ou pneumatique, de telle sorte que grâce au joint d'étanchéité activé et appliqué de façon étanche contre ledit contour, une fermeture complètement étanche ou une séparation étanche soit réalisée.
